# EUROPEAN PATENT SPECIFICATION

(11) **EP 4 319 531 B1**
(45) Date of publication and mention of the grant of the patent: **10.09.2025**
(21) Application number: 23175340.1
(22) Date of filing: 25.05.2023
(51) Int. Cl.: H10B 41/10, H10B 41/27, H10B 41/40, H10B 41/50, H10B 43/10, H10B 43/27, H10B 43/40, H10B 43/50, G11C 16/08, G11C 16/04

(54) **THREE DIMENSIONAL NON-VOLATILE MEMORY DEVICE**
DREIDIMENSIONALE NICHTFLÜCHTIGE SPEICHERANORDNUNG
DISPOSITIF DE MÉMOIRE NON VOLATILE TRIDIMENSIONNELLE

(30) Priority: 05.08.2022 KR 20220098125
(43) Date of publication of application: 07.02.2024
(73) Proprietor: Samsung Electronics Co., Ltd., Suwon-si, Gyeonggi-do 16677 (KR)
(72) Inventor: KIM, Seungyeon, Suwon-si, Gyeonggi-do 16677 (KR); FUTATSUYAMA, Takuya, Suwon-si, Gyeonggi-do 16677 (KR); PARK, Jooyong, Suwon-si, Gyeonggi-do 16677 (KR); CHO, Beakhyung, Suwon-si, Gyeonggi-do 16677 (KR)
(74) Representative: Kuhnen & Wacker Patent- und Rechtsanwaltsbüro PartG mbB

(56) References cited:
- KR-A- 20210 097 463
- KR-A- 20220 037 633
- US-A1- 2020 388 630
- US-A1- 2021 366 919

## Description

### TECHNICAL FIELD

The inventive concept relates to a memory device, and more particularly, to a three-dimensional non-volatile memory device.

### DISCUSSION OF THE RELATED ART

US 2021/366919 A1 discloses a three dimensional non-volatile memory device comprising: a plurality of memory cells in a first semiconductor layer electrically connected to a plurality of bit lines, each of the plurality of bit lines extending in a first direction, and a plurality of word lines stacked in a vertical direction, each of the plurality of word lines extending in plane formed by a second direction, a plurality of word line pads which correspond to the plurality of word lines and are arranged in a stair shape along the second direction, and a plurality of word line contacts connected to the plurality of word line pads; and a second semiconductor layer including a plurality of pass transistors electrically connected to the plurality of word line contacts, wherein an area of the plurality of the pass transistors is overlapping with an area of the plurality of word line pads in the vertical direction, wherein the plurality of word line pads has a first width in the first direction and a second width in the second direction; each of the plurality of pass transistors has a first pitch in the first direction and a second pitch in the second direction, and wherein heights of the plurality of word line pads in the vertical direction differ from one another.

KR 2022 0037633 A discloses a memory device and a manufacturing method thereof. The memory device of the present invention comprises: a first gate conductive pattern disposed to horizontally extend on a cell area and a contact area, and including first and second horizontal parts extending to the contact area in parallel, and a third horizontal part connected to one ends of the first and second horizontal parts; a first insulating pattern disposed between the first and second horizontal parts of the first gate conductive pattern; a second gate conductive pattern disposed at a lower portion of the first gate conductive pattern in parallel with the first gate conductive pattern, and including fourth and fifth horizontal parts extending to the contact area in parallel, and a sixth horizontal part connected to one ends of the fourth and fifth horizontal parts; a first gate contact structure extending vertically on the contact area, and being in contact with the third horizontal part of the first gate conductive pattern; and a second gate contact structure extending vertically on the contact area, penetrating the first insulating pattern and being in contact with the sixth horizontal part of the second gate conductive pattern. Therefore, operational reliability can be improved.

US 2020/388630 A1 discloses a memory device including: a memory cell array disposed in a first semiconductor layer, the memory cell array including a plurality of wordlines extended in a first direction and stacked in a second direction substantially perpendicular to the first direction; and a plurality of pass transistors disposed in the first semiconductor layer, wherein a first pass transistor of the plurality of pass transistors is disposed between a first signal line of a plurality of signal lines and a first wordline of the plurality of wordlines, and wherein the plurality of signal lines are arranged at the same level as a common source line.

KR 2021 0097463 A discloses a semiconductor memory device and a manufacturing method thereof. The semiconductor memory device comprises: a peripheral transistor; a first insulating film covering the peripheral transistor; a source film on the first insulating film; a laminate on the source film; and a peripheral contact structure electrically connected to the peripheral transistor through the laminate and the source film, wherein the laminate includes a stepped structure including a step side surface and a step top surface and the peripheral contact structure is in contact with the step side surface. Therefore, the semiconductor memory device can increase operation reliability.

Memory devices are devices that may be used to store data. Memory devices may be categorized as either volatile memory devices or non-volatile memory devices. To meet the need for high-capacity and miniaturized, non-volatile memory devices may be designed as three-dimensional memory devices where a memory cell array and a peripheral circuit are arranged in a vertical direction. To implement high-capacity non-volatile memory devices, as the number of word lines stacked on a substrate increases, the number of pass transistors connected to the word lines may increase. Therefore, the number, length, and complexity of connection wirings for connections between word lines and pass transistors may increase, and due to this, the reliability of memory devices may be reduced due to a coupling defect between the connection wirings.

### SUMMARY

The invention is set out in the appended claims.

Embodiments of the invention are defined in the appended claims.

A non-volatile memory device includes a first semiconductor layer including a plurality of memory cells electrically connected to a plurality of bit lines each extending in a first direction and a plurality of word lines which each extend in a second direction and are stacked in a vertical direction. A plurality of word line pads, which respectively correspond to the plurality of word lines, are arranged in a stair shape. A plurality of word line contacts are respectively electrically connected to the plurality of word line pads. A second semiconductor layer including a plurality of pass transistors is respectively electrically connected to the plurality of word line contacts and respectively overlaps the plurality of word line pads in the vertical direction. Each of the plurality of word line pads has a first width in the first direction and a second width in the second direction, and each of the plurality of pass transistors has a second pitch in the first direction and a second pitch in the second direction.

A non-volatile memory device includes an upper memory block and a lower memory block adjacent to each other in a first direction. A plurality of upper word line pads is electrically connected to the upper memory block and is arranged adjacent to the upper memory block in the second direction in a stair shape. A plurality of lower word line pads is electrically connected to the lower memory block and is arranged adjacent to the lower memory block in the second direction in a stair shape. A plurality of upper word line contacts are respectively electrically connected to the plurality of upper word line pads. A plurality of lower word line contacts are respectively electrically connected to the plurality of lower word line pads. A plurality of upper pass transistors are respectively electrically connected to the plurality of upper word line contacts and respectively overlap the plurality of upper word line pads in a vertical direction. A plurality of lower pass transistors are respectively electrically connected to the plurality of lower word line contacts and respectively overlap the plurality of lower word line pads in the vertical direction. The plurality of upper word line pads and the plurality of lower word line pads have a same width in the second direction, and each of the plurality of upper pass transistors and the plurality of lower pass transistors has a same pitch in the second direction.

A non-volatile memory device includes a plurality of memory cells electrically connected to a plurality of bit lines, each extending in a first direction, and a plurality of word lines, each extending in a second direction and stacked in a vertical direction. A plurality of word line pads, which respectively correspond to the plurality of word lines, are arranged in a stair shape. A plurality of word line contacts are respectively electrically connected to the plurality of word line pads. A plurality of pass transistors are respectively electrically connected to the plurality of word line contacts and respectively overlap the plurality of word line pads in the vertical direction The plurality of word line pads have a same width in the second direction, and each of the plurality of word line contacts and the plurality of pass transistors has a first pitch in the second direction.

### BRIEF DESCRIPTION OF THE DRAWINGS

Embodiments will be more clearly understood from the following detailed description taken in conjunction with the accompanying drawings in which:
FIG. 1 is a block diagram illustrating a memory device according to an embodiment;
FIG. 2 is a perspective view illustrating a structure of a memory device according to an embodiment;
FIG. 3 is a perspective view illustrating a memory cell array according to an embodiment;
FIG. 4 is a schematic diagram illustrating a row decoder, a pass transistor circuit, and a memory block according to an embodiment;
FIG. 5 is a circuit diagram illustrating a pass transistor circuit and a first memory block according to an embodiment;
FIG. 6 is a perspective view illustrating a memory device according to an embodiment;
FIGS. 7A and 7B each illustrate a word line pad structure according to embodiments;
FIG. 8 is a plan view illustrating the memory device of FIG. 6 according to an embodiment;
FIG. 9A is a side view of the memory device of FIG. 6 in a second direction, according to an embodiment;
FIG. 9B is a side view of the memory device of FIG. 6 in a first direction, according to an embodiment;
FIG. 9C is a side view of a memory device in a first direction, according to an embodiment;
FIG. 10A is a side view of a memory device in a second direction, according to an embodiment;
FIG. 10B is a side view of a memory device in a first direction, according to an embodiment;
FIG. 11A is a side view of a memory device in a second direction, according to an embodiment;
FIG. 11B is a side view of a memory device in a first direction, according to an embodiment;
FIG. 12A is a side view of a memory device in a second direction, according to an embodiment;
FIG. 12B is a side view of a memory device in a first direction, according to an embodiment;
FIG. 13 is a perspective view illustrating a memory device according to an embodiment;
FIG. 14A is a side view of the memory device of FIG. 13 in a second direction, according to an embodiment;
FIG. 14B is a side view of the memory device of FIG. 13 in a first direction, according to an embodiment;
FIGS. 15A to 15C are cross-sectional views illustrating a memory device according to embodiments;
FIG. 16 is a perspective view illustrating a memory device according to an embodiment;
FIG. 17A is a plan view of the memory device of FIG. 16 according to an embodiment;
FIG. 17B is a side view of the memory device of FIG. 16 according to an embodiment;
FIG. 18A is a plan view of a memory device according to an embodiment;
FIG. 18B is a side view of the memory device of FIG. 18A according to an embodiment;
FIG. 19 is a perspective view illustrating a memory device according to an embodiment;
FIG. 20 is a side view of the memory device of FIG. 19 according to an embodiment;
FIG. 21 is a perspective view illustrating a memory device according to an embodiment;
FIG. 22 is a side view of the memory device of FIG. 21 according to an embodiment;
FIGS. 23A and 23B are plan view illustrating a connection structure between a word line pad and a pass transistor arranged at one stage, according to embodiments;
FIGS. 24A to 24D are plan views illustrating a connection structure between a word line pad and a pass transistor arranged at two stages, according to embodiments;
FIGS. 25A and 25B are plan views illustrating a connection structure between a word line pad and a pass transistor arranged at three stages, according to embodiments;
FIG. 25C is a plan view illustrating a connection structure between a word line pad and a pass transistor arranged at four stages, according to embodiments;
FIG. 26 is a perspective view illustrating a memory device according to an embodiment;
FIGS. 27A to 27D are perspective views illustrating a word line pad structure according to embodiments;
FIG. 28 is a side view illustrating a memory device according to an embodiment;
FIG. 29A is a plan view illustrating pass transistors according to an embodiment;
FIG. 29B is a plan view illustrating a word line pad structure according to an embodiment;
FIGS. 30A and 30B are side views each illustrating a memory device according to embodiments;
FIGS. 31A and 31B are plan views each illustrating a wiring for a word line driving signal in a memory device according to embodiments;
FIGS. 32A to 32C are plan views each illustrating a memory device according to embodiments; and
FIG. 33 is a cross-sectional view of a memory device having a B-VNAND structure, according to an embodiment.

### DETAILED DESCRIPTION OF THE EMBODIMENTS

Hereinafter, embodiments will be described in detail with reference to the accompanying drawings.

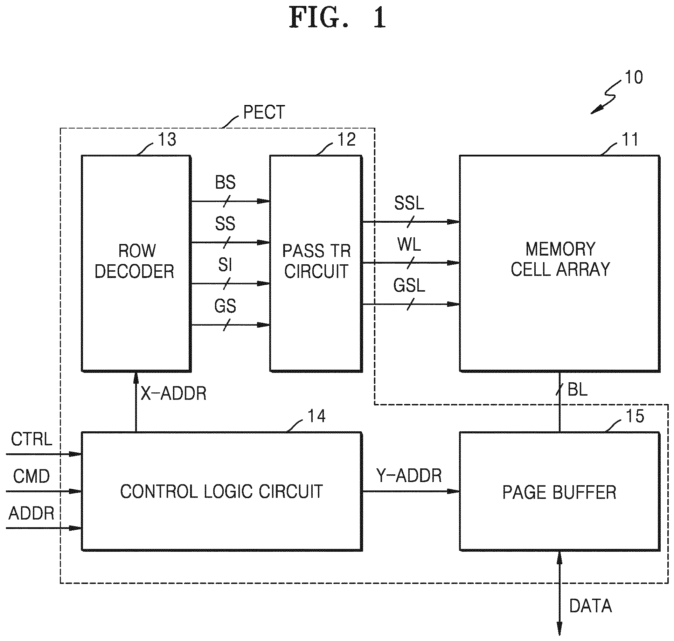

FIG. 1 is a block diagram illustrating a memory device 10 according to an embodiment.

Referring to FIG. 1, the memory device 10 may include a memory cell array 11 and a peripheral circuit PECT, and the peripheral circuit PECT may include a pass transistor circuit 12, a row decoder 13, a control logic circuit 14, and a page buffer circuit 15. The peripheral circuit PECT may further include a voltage generator, a data input/output (I/O) circuit, an I/O interface, a temperature sensor, a command decoder, or an address decoder. In embodiments, the memory device 10 may include a non-volatile memory device. Hereinafter, a "memory device" may be referred to as a non-volatile memory device.

The memory cell array 11 may be electrically connected to the pass transistor circuit 12 through word lines WL, string selection lines SSL, and ground selection lines GSL and may be electrically connected to the page buffer circuit 15 through bit lines BL. The memory cell array 11 may include a plurality of memory cells, and for example, the memory cells may be flash memory cells. Hereinafter, a case where a plurality of memory cells are NAND flash memory cells will be described as an example of embodiments. However, the inventive concept is not necessarily limited thereto, and in some embodiments, a plurality of memory cells may be resistive memory cells, such as resistive random access memory (RAM) (ReRAM) memory cells, phase change RAM (PRAM) memory cells, or magnetic RAM (MRAM) memory cells.

In an embodiment, the memory cell array 11 may include a three-dimensional (3D) memory cell array, the 3D memory cell array may include a plurality of NAND strings, and each of the NAND strings may include memory cells respectively electrically connected to word lines, which are vertically stacked on a substrate. U.S. Patent Publication Nos. 7,679,133, 8,553,466, 8,654,587 and 8,559,235 and U.S. Patent Application No. 201110233648, may disclose appropriate elements of a 3D memory array which is configured at a plurality of levels and where word lines and/or bit lines are shared between levels. However, the inventive concept is not necessarily limited thereto, and in some embodiments, the memory cell array 11 may include a two-dimensional (2D) memory cell array, and the 2D memory cell array may include a plurality of NAND strings which are arranged in row and column directions.

The control logic circuit 14 may program data in the memory cell array 11, based on a command CMD, an address ADDR, and a control signal CTRL, read data from the memory cell array 11, or generate various control signals for erasing data stored in the memory cell array 11. For example, the control logic circuit 14 may output a row address X-ADDR and a column address Y-ADDR. Therefore, the control logic circuit 14 may overall control various operations of the memory device 10.

In response to the row address X-ADDR, the row decoder 13 may output, to block selection signal lines BS, a block selection signal for selecting one memory block from among a plurality of memory blocks. In addition, in response to the row address X-ADDR, the row decoder 13 may output, to word line driving signal lines SI, a word line driving signal for selecting one word line WL from among word lines WL of a selected memory block, may output, to string selection line driving signal lines SS, a string selection line driving signal for selecting one string selection line SSL from among string selection lines SSL, and may output, to ground selection line driving signal lines GS, a ground selection line driving signal for selecting one ground selection line GSL from among ground selection lines GSL. In some embodiments, a word line driving signal line SI may be referred to as a "global word line". The page buffer circuit 15 may select some bit lines from among bit lines BL in response to the column address Y-ADDR. For example, the page buffer circuit 15 may operate as a write driver or a sense amplifier, based on an operation mode.

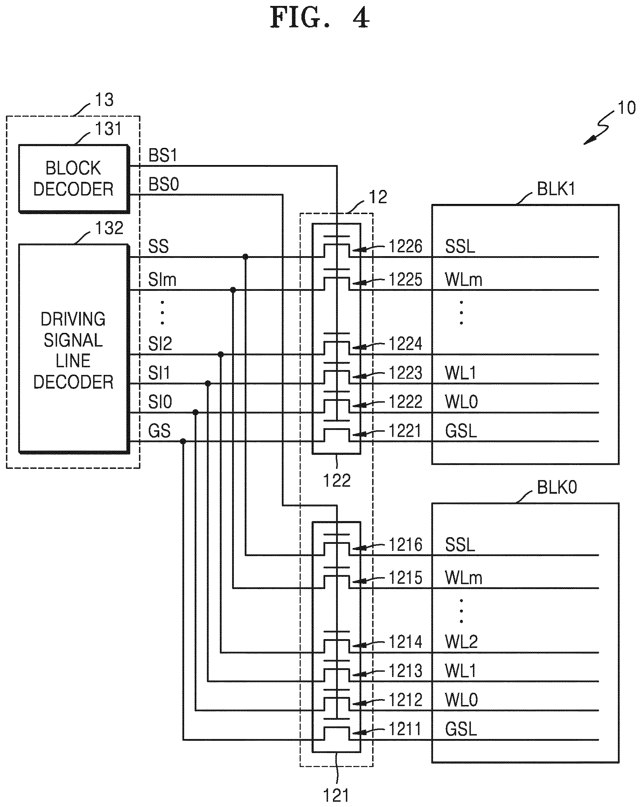

The pass transistor circuit 12 may be electrically connected to the row decoder 13 through the block selection signal lines BS, the string selection line driving signal lines SS, the word line driving signal lines SI, and the ground selection line driving signal lines GS. The string selection line driving signal lines SS, the word line driving signal lines SI, and the ground selection line driving signal lines GS may be referred to as "driving signal lines". The pass transistor circuit 12 may include a plurality of pass transistors (for example, 1211 to 1226 of FIG. 4), the plurality of pass transistors may be controlled by block selection signals received through the block selection signal lines BS, and the string selection line driving signals, the word line driving signals, and the ground selection line driving signals may be respectively provided to the string selection lines SSL, the word lines WL, and the ground selection lines GSL.

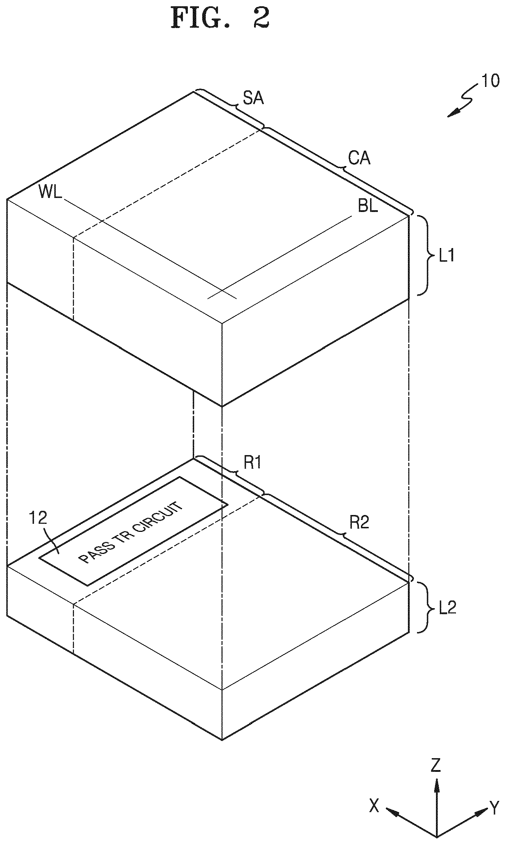

With the advance of a semiconductor process, as the number of memory cells provided in the memory cell array 11 increases, for example, the number of word lines WL stacked in a vertical direction increases, the number of pass transistors for driving the word lines WL may increase, and thus, an area occupied by the pass transistor 12 may increase. According to an embodiment, the peripheral circuit PECT may be disposed above or below the memory cell array 11 in a vertical direction, and particularly, the pass transistor circuit 12 may be disposed above or below a stair area of the word lines WL or a word line extension area (for example, SA of FIG. 2) in the vertical direction. Accordingly, an area where the pass transistor circuit 12 is disposed overlaps a stair area of the word lines WL in the vertical direction, and thus, an increase in chip size of the memory device 10 may be prevented despite an increase in the number of pass transistors caused by an increase in the number of stacks of the word lines WL. This will be described in more detail with reference to FIG. 2.

FIG. 2 schematically illustrates a structure of a memory device 10 according to an embodiment.

Referring to FIGS. 1 and 2, the memory device 10 may include a first semiconductor layer L1 and a second semiconductor layer L2, and the first semiconductor layer L1 may be stacked on the second semiconductor layer L2 in a vertical direction Z. For example, the second semiconductor layer L2 may be arranged below the first semiconductor layer L1 in the vertical direction Z. In an embodiment, the memory cell array 11 may be provided in the first semiconductor layer L1, and the peripheral circuit PECT may be provided in the second semiconductor layer L2. Therefore, the memory device 10 may have a structure (for example, a cell over periphery (COP) structure or a bonding VNAND (B-VNAND) structure) where the memory cell array 11 is disposed on some peripheral circuits.

The first semiconductor layer L1 may include a cell area CA and a stair area SA, and a plurality of memory cells may be disposed in the cell area CA. In the first semiconductor layer L1, a plurality of bit lines BL may extend in a first direction Y, and a plurality of word lines WL may extend in a second direction X. Ends of the plurality of word lines WL may be implemented in a stair shape, and herein, a region including the plurality of word lines WL having a stair shape in the first semiconductor layer L1 may be referred to a "stair area SA", a "word line extension area", or an "extension area". In an embodiment, ends of the plurality of word lines WL may be arranged in a stair shape based on the first direction Y and the second direction X, and end portions of the stair shape may be referred to as "word line pads". Each of word line pads may be electrically connected to a corresponding pass transistor through a word line contact.

The second semiconductor layer L2 may include a substrate and a pattern for interconnecting elements and semiconductor devices, such as a transistor, may be formed on the substrate, and thus, the peripheral circuit PECT may be provided in the second semiconductor layer L2. The second semiconductor layer L2 may include a first region R1 corresponding to the stair area SA and a second region R2 corresponding to the cell area CA. In an embodiment, the pass transistor circuit 12 may be disposed in the first region R1, but the inventive concept is not necessarily limited thereto.

In an embodiment, when the memory device 10 has the COP structure, after the peripheral circuit PECT is formed in the second semiconductor layer L2, the first semiconductor layer L1 including the memory cell array 11 may be formed, and patterns for electrically connecting the word lines WL and the bit lines BL of the memory cell array 11 to the peripheral circuit PECT provided in the second semiconductor layer L2 may be formed. In an embodiment, when the memory device 10 has a B-VNAND structure, the peripheral circuit PECT and bottom bonding pads may be formed in the second semiconductor layer L2 and the memory cell array 11 and top bonding pads may be formed in the first semiconductor layer L1, and then, the top bonding pads of the first semiconductor layer L1 may be connected to the bottom bonding pads of the second semiconductor layer L2 by using a bonding scheme.

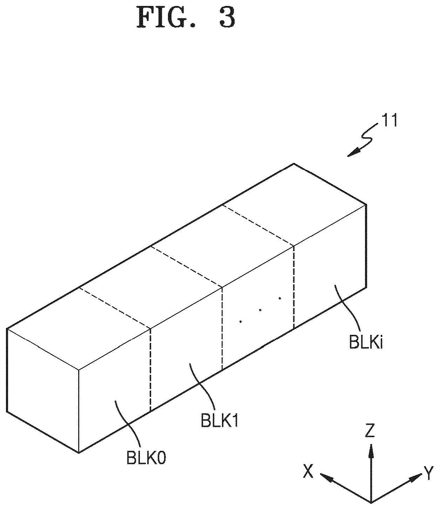

FIG. 3 schematically illustrates a memory cell array 11 according to an embodiment. Referring to FIG. 3, the memory cell array 11 may include a plurality of memory blocks BLKO to BLKi (where i is a positive integer). Each of the plurality of memory blocks BLKO to BLKi may have a 3D structure (or a vertical structure). For example, each of the plurality of memory blocks BLKO to BLKi may include a plurality of NAND strings which extend in a vertical direction Z. In this case, the plurality of NAND strings may be spaced apart from one another by a certain distance in first and second directions X and Y. The plurality of memory blocks BLKO to BLKi may be selected by a row decoder (13 of FIG. 1). For example, the row decoder 13 may select a memory block corresponding to a block address from among the plurality of memory blocks BLKO to BLKi.

FIG. 4 illustrates a row decoder 13, a pass transistor circuit 12, and first and second memory blocks BLKO and BLK1, according to an embodiment.

Referring to FIG. 4, a memory device 10 may include the pass transistor circuit 12, and the pass transistor circuit 12 may include a plurality of pass transistor circuits respectively corresponding to a plurality of memory blocks (for example, BLKO to BLKi of FIG. 3). The first and second memory blocks BLKO and BLK1 may be disposed adjacent to each other, and each of the first and second memory blocks BLKO and BLK1 may include a ground selection line GSL, a plurality of word lines WLO to WLm (where m is a positive integer), and a string selection line SSL.

The row decoder 13 may include a block decoder 131 and a driving signal line decoder 132. The pass transistor circuit 12 may include a first pass transistor circuit 121 corresponding to the first memory block BLKO and a second pass transistor circuit 122 corresponding to the second memory block BLK1. The first pass transistor circuit 121 may include a plurality of pass transistors 1211 to 1216, and the second pass transistor circuit 122 may include a plurality of pass transistors 1221 to 1226.

The block decoder 131 may be electrically connected to the first pass transistor circuit 121 through a first block selection signal line BSO and may be electrically connected to the second pass transistor circuit 122 through a second block selection signal line BS1. The first block selection signal line BSO may be electrically connected to gates of the plurality of pass transistors 1211 to 1216. For example, when the first block selection signal provided through the first block selection signal line BSO is activated, the plurality of pass transistors 1211 to 1216 may be turned on, and thus, the first memory block BLKO may be selected. Also, the second block selection signal line BS1 may be electrically connected to gates of the plurality of pass transistors 1221 to 1226. For example, when the second block selection signal provided through the second block selection signal line BS1 is activated, the plurality of pass transistors 1221 to 1226 may be turned on, and thus, the second memory block BLK1 may be selected.

The driving signal line decoder 132 may be electrically connected to the first and second pass transistor circuits 121 and 122 through a string selection line driving signal line SS, word line driving signal lines SI1 to SIm, and a ground selection line driving signal line GS. For example, the string selection line driving signal line SS, the word line driving signal lines SI0 to SIm, and the ground selection line driving signal line GS may be respectively electrically connected to sources of the plurality of pass transistors 1211 to 1216 and 1221 to 1226.

The first pass transistor circuit 121 may be electrically connected to the first memory block BLKO through the ground selection line GSL, the plurality of word lines WLO to WLm, and the string selection line SSL. The pass transistor 1211 may be electrically connected between the ground selection line driving signal line GS and the ground selection line GSL. The pass transistors 1212 to 1215 may be respectively electrically connected to the word line driving signal lines SI1 to SIm and the plurality of word lines WL0 to WLm. The pass transistor 1216 may be electrically connected between the string selection line driving signal line SS and the string selection line SSL. For example, when the first block selection signal is activated, the pass transistors 1211 to 1216 may respectively provide driving signals, provided through the ground selection line driving signal line GS, the word line driving signal lines SI1 to SIm, and the string selection line driving signal line SS, to the ground selection line GSL, the plurality of word lines WLO to WLm, and the string selection line SSL. The description of the first pass transistor circuit 121 may be applied to the second pass transistor circuit 122, and thus, to the extent that a detailed description of an element has been omitted, it may be assumed that the element may be at least similar to a corresponding element that has been described elsewhere within the present disclosure.

In FIG. 4, an example where block sharing is not performed on the first and second memory blocks BLKO and BLK1 is illustrated. Therefore, gates of the pass transistors 1211 to 1216 included in the first pass transistor circuit 121 may be electrically connected to the first block selection signal line BS0, and gates of the pass transistors 1221 to 1226 included in the second pass transistor circuit 122 may be electrically connected to the second block selection signal line BS1. In this case, a source of each pass transistor (for example, 1212) included in the first pass transistor circuit 121 and a source of each pass transistor (for example, 1222) included in the second pass transistor circuit 122 may be electrically connected to the same word line driving signal line (for example, SI0). As described above, in a case where block sharing is not performed, the number of driving signal lines extending in a first direction Y on each pass transistor may correspond to the number of stages of pass transistors corresponding to a height of a memory block (i.e., a block height) in the first direction Y.

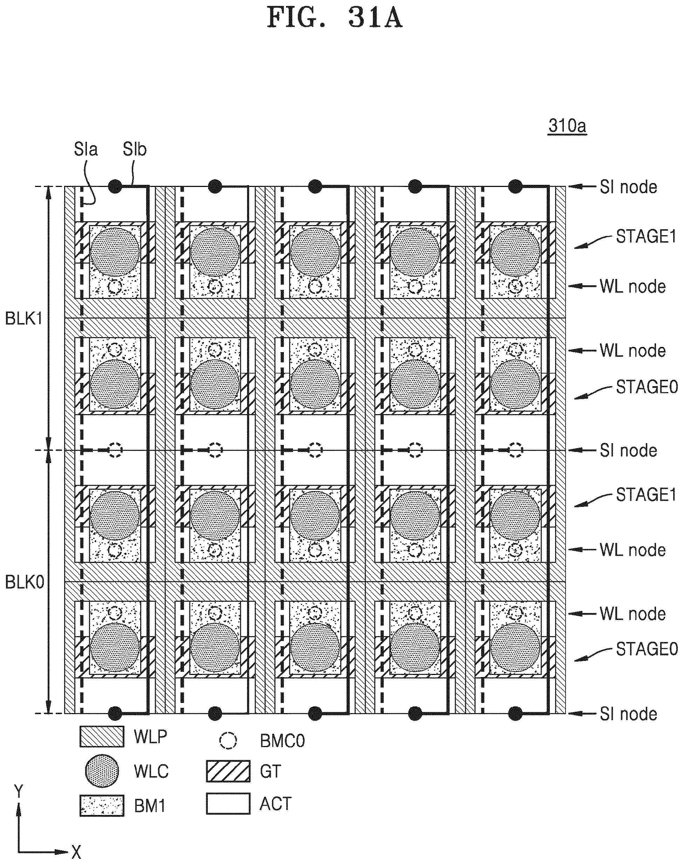

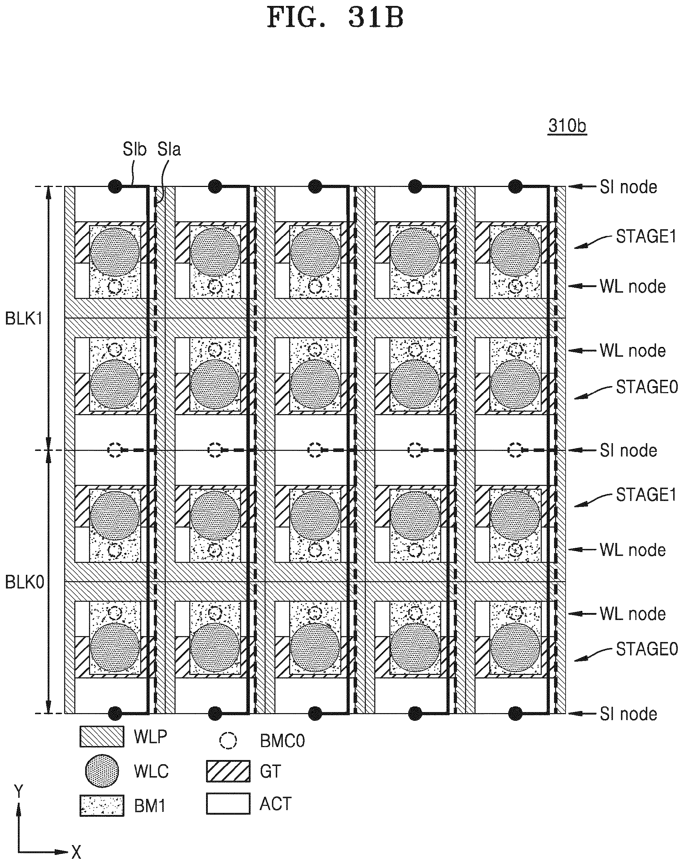

In some embodiments, block sharing may be performed on the first and second memory blocks BLKO and BLK1. Therefore, gates of the pass transistors 1211 to 1216 included in the first pass transistor circuit 121 and gates of the pass transistors 1221 to 1226 included in the second pass transistor circuit 122 may be electrically connected to the same block selection signal line. In this case, the source of each pass transistor (for example, 1212) included in the first pass transistor circuit 121 and the source of each pass transistor (for example, 1222) included in the second pass transistor circuit 122 may be respectively electrically connected to different word line driving signal lines. As described above, in a case where block sharing is performed, the number of driving signal lines extending in the first direction Y on each pass transistor may correspond to the multiplication of the number of stages of pass transistors, corresponding to a height of a memory block (i.e., a block height) in the first direction Y, by the number of shared memory blocks. This will be described below in more detail with reference to FIGS. 31A and 31B.

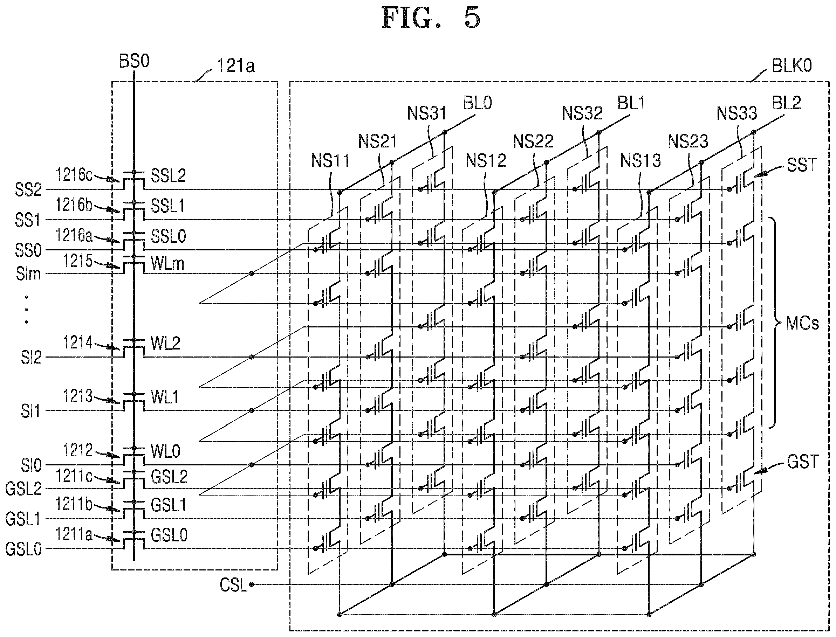

FIG. 5 is a circuit diagram illustrating a pass transistor circuit 121a and a first memory block BLKO according to an embodiment.

Referring to FIG. 5, the pass transistor circuit 121a may correspond to an implementation example of the first pass transistor circuit 121 of FIG. 4. In an embodiment, a second pass transistor circuit 122 may be implemented substantially similar to the pass transistor circuit 121a, and a second memory block BLK1 may be implemented substantially similar to the first memory block BLKO. The first memory block BLKO may include a plurality of NAND strings NS11 to NS33, a plurality of word lines WLO to WLm, a plurality of ground selection lines GSLO to GSL2, a plurality of string selection lines SSLO to SSL2, and a common source line CSL. Here, the number of NAND strings, the number of word lines, the number of bit lines, the number of ground selection lines, and the number of string selection lines may be variously changed according to an embodiment.

The NAND strings NS11, NS21, and NS31 may be provided between the bit line BL0 and the common source line CSL, the NAND strings NS12, NS22, and NS32 may be provided between the bit line BL1 and the common source line CSL, and the NAND strings NS13, NS23, and NS33 may be provided between the bit line BL2 and the common source line CSL. Each NAND string (for example, NS33) may include a string selection transistor SST, a plurality of memory cells MCs, and a ground selection transistor GST, which are serially electrically connected to one another.

The string selection transistor SST may be electrically connected to corresponding string selection lines SSLO to SSL2. Each of the plurality of memory cells MCs may be electrically connected to corresponding word lines WLO to WLm. The ground selection transistor GST may be electrically connected to corresponding ground selection lines GSLO to GSL2. The string selection transistor SST may be electrically connected to corresponding bit lines BL0 to BL2, and the ground selection transistor GST may be electrically connected to the common source line CSL.

In an embodiment, word lines (for example, WL1) arranged at the same level may be electrically connected to one another in common, the string selection lines SSLO to SSL2 may be spaced apart from one another, and the ground selection lines GSLO to GSL2 may be spaced apart from one another. In FIG. 5, it is illustrated that three string selection lines SSLO to SSL2 share a word line disposed at the same height, but the inventive concept is not necessarily limited thereto. For example, two string selection lines may share a word line disposed at the same height. As an example, four string selection lines may share a word line disposed at the same height.

The pass transistor circuit 121a may include pass transistors 1211a to 1211c respectively electrically connected to the ground selection lines GSLO to GSL2, pass transistors 1212 to 1215 respectively electrically connected to the word lines WLO to WLm, and pass transistors 1216a to 1216c respectively electrically connected to the string selection lines SSLO to SSL2. The pass transistors 1211a to 1211c, 1212 to 1215, and 1216a to 1216c may be turned on based on a first block selection signal provided along a first block selection signal line BSO and may respectively provide driving signals, provided through the string selection line driving signal lines SS0 to SS2, the word line driving signal lines SI0 to SIm, and the ground selection line driving signal lines GS0 to SG2, to the string selection lines SSLO to SSL2, the plurality of word lines WLO to WLm, and the ground selection lines GSLO to GSL2.

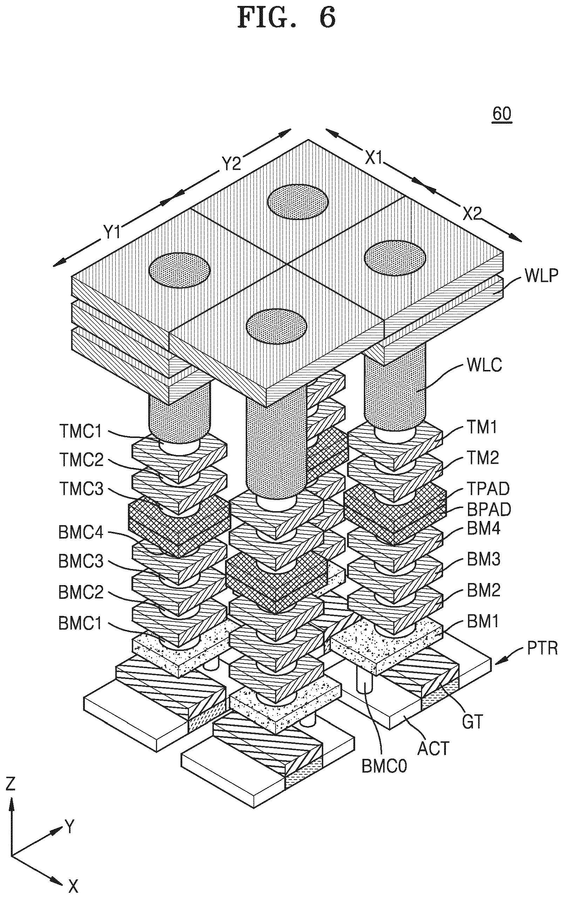

FIG. 6 is a perspective view illustrating a memory device 60 according to an embodiment. Descriptions given above with reference to FIGS. 1 to 5 may be applied to the present embodiment, and to the extent that a detailed description of an element has been omitted, it may be assumed that the element may be at least similar to a corresponding element that has been described elsewhere within the present disclosure.

Referring to FIG. 6, the memory device 60 may include a plurality of word line pads WLP arranged in a first direction Y and a second direction X and a plurality of word line contacts WLC arranged in the first direction Y and the second direction X. The plurality of word line pads WLP may respectively correspond to a plurality of word lines (for example, WLO to WLm of FIG. 5) and may respectively correspond to the plurality of word line contacts WLC. As described above, each of the word line pads WLP may be defined as a region where each word line WL is electrically connected to each word line contact WLC. For example, each word line pad WLP may be implemented in a rectangular shape or a square shape. In an embodiment, each word line contact WLC may pass through each word line pad WLP, and thus, heights of the plurality of word line contacts WLC may be equal in a vertical direction Z.

The memory device 60 may further include a plurality of pass transistors PTR. Each word line pad WLP may be electrically connected to each word line contact WLC, and each word line contact WLC may be electrically connected to a corresponding pass transistor PTR through a plurality of top metal layers TM1 and TM2, a plurality of top metal contacts TMC1 to TMC3, a top bonding pad TPAD, a bottom bonding pad BPAD, a plurality of bottom metal layers BM1 to BM4, and a plurality of bottom metal contacts BMCO to BMC4. Each pass transistor PTR may include an active area ACT and a gate terminal GT. Each word line pad WLP may be electrically connected to the active area ACT (for example, a drain terminal) of each pass transistor PTR. For example, the plurality of word line pads WLP, the plurality of word line contacts WLC, the plurality of top metal layers TM1 and TM2, the plurality of top metal contacts TMC1 to TMC3, and the top bonding pad TPAD may be included in a first semiconductor layer (for example, L1 of FIG. 2), and the bottom bonding pad BPAD, the plurality of bottom metal layers BM1 to BM4, the plurality of bottom metal contacts BMCO to BMC4, and the plurality of pass transistors PTR may be included in a second semiconductor layer (for example, L2 of FIG. 2).

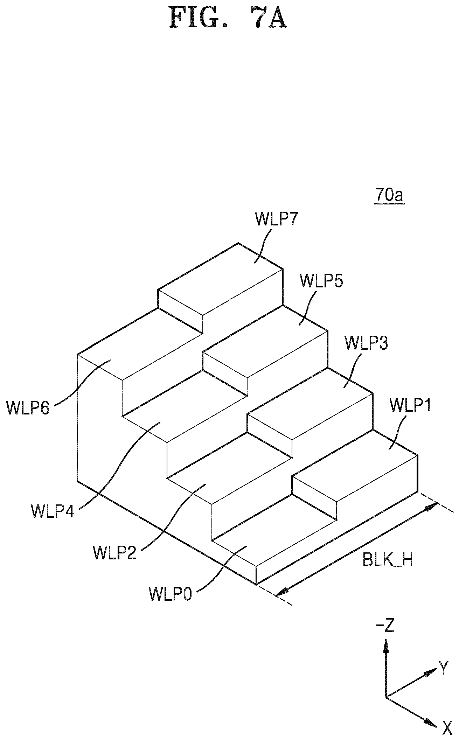

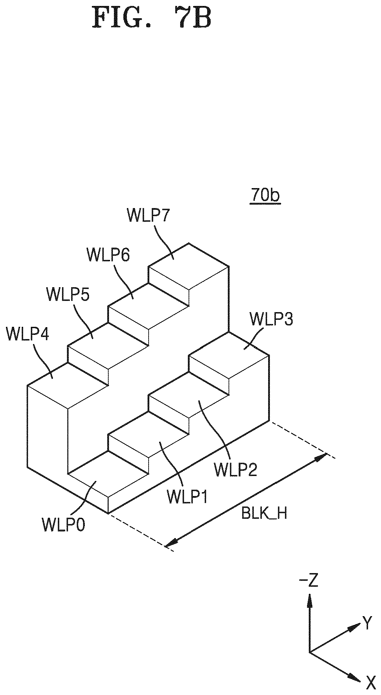

Word line pads adjacent to each other in the first direction Y, among the plurality of word line pads WLP, may have different heights in the vertical direction Z, and word line pads adjacent to each other in the second direction X, among the plurality of word line pads WLP, may have different heights in the vertical direction Z. As described above, the plurality of word line pads WLP may be implemented in a stair shape. For example, the plurality of word line pads WLP may be formed by a stair dividing patterning (SDP) process. For example, a maximum number of word line pads WLP may be formed with a minimum number of layers by using a step between the first direction Y and the second direction X, based on the SDP process. Hereinafter, a word line pad structure will be described in more detail with reference to FIGS. 7A and 7B.

FIG. 7A illustrates a word line pad structure 70a according to an embodiment.

Referring to FIG. 7A, the word line pad structure 70a may be formed by a 2-SDP process, and thus, may include two word line pads having different heights in a first direction Y and four word line pads having different heights in a second direction X. In this case, a length of the word line pad structure 70a in the first direction Y may correspond to a length of one memory block (i.e., a block height BLK_H) in the first direction Y. A word line pad structure of the related art includes eight word line pads having different heights in the second direction X. However, the word line pad structure 70a, according to an embodiment, may include eight word line pads WLP0 to WLP7 having different heights in the first direction Y and the second direction X, and thus, comparing with the related art, a length in the second direction X may decrease by half.

FIG. 7B illustrates a word line pad structure 70b according to an embodiment.

Referring to FIG. 7B, the word line pad structure 70b may be formed by a 4-SDP process, and thus, may include four word line pads having different heights in a first direction Y and two word line pads having different heights in a second direction X. In this case, a length of the word line pad structure 70b in the first direction Y may correspond to a length of one memory block (i.e., a block height BLK_H) in the first direction Y. The word line pad structure 70b according to an embodiment may include eight word line pads WLP0 to WLP7 having different heights in the first direction Y and the second direction X, and thus, comparing with the word line pad structure 70a of FIG. 7A, a length in the second direction X may decrease by half.

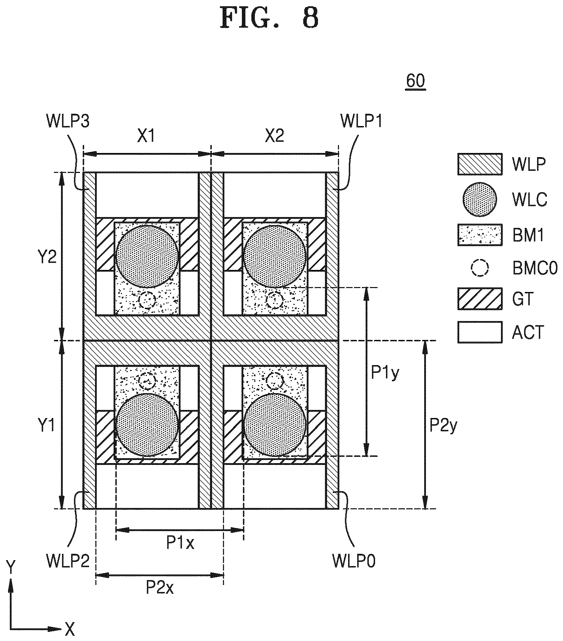

FIG. 8 is a plan view illustrating the memory device 60 of FIG. 6 according to an embodiment.

Referring to FIGS. 6 and 8, the memory device 60 may include first to fourth word line pads WLP0 to WLP3 which are arranged in a first direction Y and a second direction X. The first and second word line pads WLP0 and WLP1 adjacent to each other in the first direction Y and the third and fourth word line pads WLP2 and WLP3 adjacent to each other in the first direction Y may have the same width in the first direction Y. For example, the first word line pad WLP0 may have a first width Y1 in the first direction Y, the second word line pad WLP1 may have a second width Y2 in the first direction Y, and the first width Y1 may be equal to the second width Y2. The first and third word line pads WLP0 and WLP2 adjacent to each other in the second direction X and the second and fourth word line pads WLP1 and WLP3 adjacent to each other in the second direction X may have the same width in the second direction X. For example, the third word line pad WLP2 may have a first width X1 in the second direction X, the first word line pad WLP0 may have a second width X2 in the second direction X, and the first width X1 may be equal to the second width X2. However, the inventive concept is not necessarily limited thereto, and the first and second word line pads WLP0 and WLP1 adjacent to each other in the first direction Y may have the same pitch in the first direction Y and the first and third word line pads WLP0 and WLP2 adjacent to each other in the second direction X may have the same pitch in the second direction X.

In an embodiment, the word line contacts WLC may have a first pitch P1x in the second direction X, and the pass transistor PTR, according to the invention, has a second pitch P2x in the second direction X. In this case, the first pitch P1x and the second pitch P2x may be equal to one another. For example, the first and second pitches P1x and P2x may be respectively equal to the first and second widths X1 and X2. As described above, in the memory device 60, pitches of word line pads WLP, word line contacts WLC, and pass transistors PTR adjacent to one another in the second direction X may be equal to one another. However, the inventive concept is not necessarily limited thereto, and in some embodiments, pitches of the pass transistors PTR in the second direction X may be equal, and pitches of the word line contacts WLC in the second direction X may be equal to one another.

In an embodiment, the word line contacts WLC may have a first pitch P1y in the first direction Y, and the pass transistor PTR, according to the invention, has a second pitch P2y in the first direction Y. In this case, the first pitch P1y and the second pitch P2y may be equal to one another. For example, the first and second pitches P1y and P2y may be respectively equal to the first and second widths Y1 and Y2. As described above, in the memory device 60, pitches of word line pads WLP, word line contacts WLC, and pass transistors PTR adjacent to one another in the first direction Y may be equal to one another. However, the inventive concept is not necessarily limited thereto, and in some embodiments, pitches of the pass transistors PTR in the first direction Y may be equal to one another, and pitches of the word line contacts WLC in the first direction Y may be equal to one another.

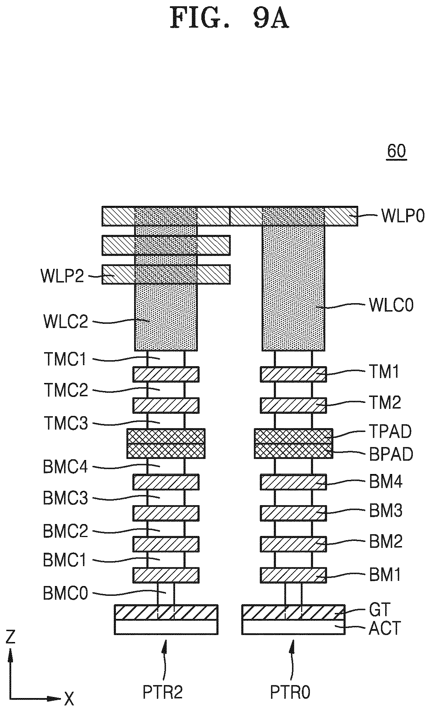

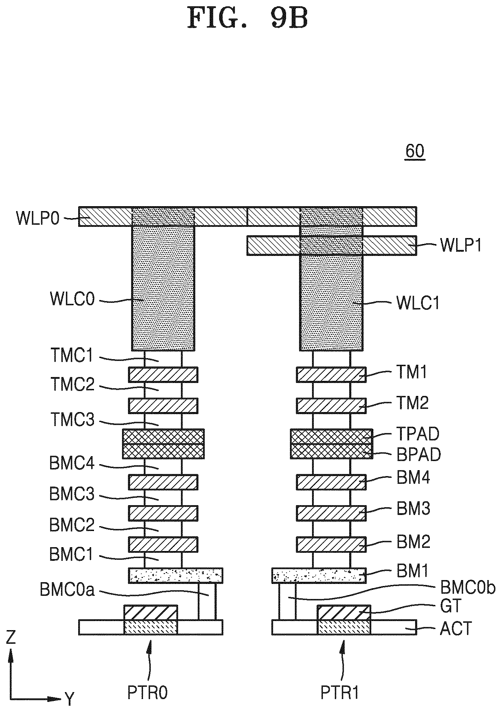

FIG. 9A is a side view of the memory device 60 of FIG. 6 in a second direction X, according to an embodiment. FIG. 9B is a side view of the memory device 60 of FIG. 6 in a first direction Y, according to an embodiment.

Referring to FIGS. 9A and 9B, first and second word line pads WLP0 and WLP1 adjacent to each other in the first direction Y may have different heights in a vertical direction Z, and first and third word line pads WLP0 and WLP2 adjacent to each other in the second direction X may have different heights in the vertical direction Z. A first word line contact WLC0 may pass through the first word line pad WLP0 and may extend in the vertical direction Z, a second word line contact WLC1 may pass through the second word line pad WLP1 and may extend in the vertical direction Z, and a third word line contact WLC2 may pass through the third word line pad WLP2 and may extend in the vertical direction Z.

The first word line contact WLC0 may be electrically connected to an active area ACT (for example, a drain terminal) of a first pass transistor PTRO through a plurality of top metal layers TM1 and TM2, a plurality of top metal contacts TMC1 to TMC3, a top bonding pad TPAD, a bottom bonding pad BPAD, a plurality of bottom metal layers BM1 to BM4, and a plurality of bottom metal contacts BMC0a to BMC4. For example, the plurality of top metal contacts TMC1 to TMC3 may be aligned with one another in the vertical direction Z. For example, the plurality of bottom metal contacts BMC1 to BMC3 may be aligned in the vertical direction Z.

The second word line contact WLC1 may be electrically connected to an active area ACT (for example, a drain terminal) of a second pass transistor PTR1 through the plurality of top metal layers TM1 and TM2, the plurality of top metal contacts TMC1 to TMC3, the top bonding pad TPAD, the bottom bonding pad BPAD, the plurality of bottom metal layers BM1 to BM4, and a plurality of bottom metal contacts BMC0b to BMC4. The third word line contact WLC2 may be electrically connected to an active area ACT (for example, a drain terminal) of a third pass transistor PTR2 through the plurality of top metal layers TM1 and TM2, the plurality of top metal contacts TMC1 to TMC3, the top bonding pad TPAD, the bottom bonding pad BPAD, the plurality of bottom metal layers BM1 to BM4, and a plurality of bottom metal contacts BMCO to BMC4.

In an embodiment, the bottom metal contacts BMC0a and BMC0b respectively electrically connected to the first and second pass transistors PTRO and PTR1 may be adjacent to each other in the first direction Y. As described above, the bottom metal contacts BMC0a and BMC0b may be disposed in a structure facing each other. For example, the first pass transistor PTRO may include a gate terminal GT and a source/drain terminal which is disposed at one side (for example, a right side in the first direction Y) of the gate terminal GT in the first direction Y and is electrically connected to the bottom metal contact BMC0a, and the second pass transistor PTR1 may include a gate terminal GT and a source/drain terminal which is disposed at one side (for example, a left side in the first direction Y) of the gate terminal GT in the first direction Y and is electrically connected to the bottom metal contact BMC0b. For example, the source/drain terminal electrically connected to the bottom metal contact BMC0a and the source/drain terminal electrically connected to the bottom metal contact BMC0b may be adjacent to each other in the first direction Y.

As described above, the first word line pad WLP0 and the first pass transistor PTRO may be electrically connected to the active area ACT (for example, the drain terminal) of the first pass transistor PTRO through connection wirings (for example, the plurality of top metal layers TM1 and TM2, the plurality of top metal contacts TMC1 to TMC3, the top bonding pad TPAD, the bottom bonding pad BPAD, the plurality of bottom metal layers BM1 to BM4, and the plurality of bottom metal contacts BMCO to BMC4) overlapping the first word line pad WLP0 in the vertical direction Z, instead of a metal line extending in the first direction Y or the second direction X. Therefore, the number, length, or complexity of connection wirings between the first word line pad WLP0 and the first pass transistor PTRO may be reduced. Also, a coupling defect between a connection wiring corresponding to the first word line pad WLP0 and a connection wiring corresponding to the second word line pad WLP1 or the third word line pad WLP2 might not occur, and thus, the operation reliability of the memory device 60 may be enhanced. Furthermore, a size of a wiring area where the connection wiring between the first word line pad WLP0 and the first pass transistor PTRO is disposed may be reduced, and thus, the degree of freedom in arrangement of other wirings may be increased.

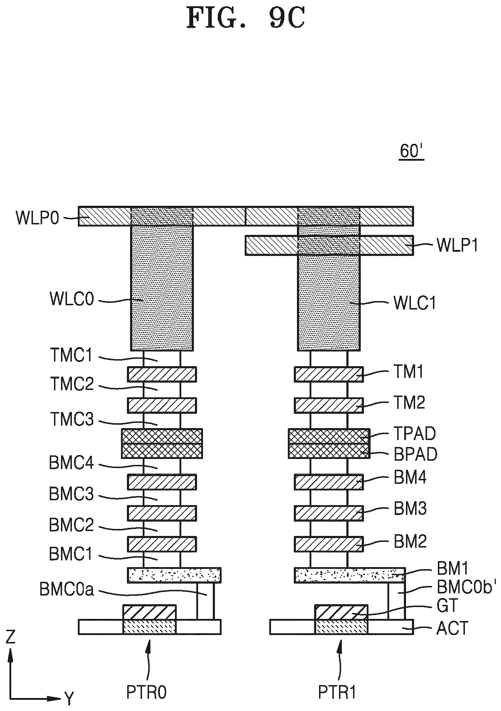

FIG. 9C is a side view of a memory device 60' in a first direction Y, according to an embodiment.

Referring to FIG. 9C, the memory device 60' may correspond to a modification example of the memory device 60 of FIG. 6, and descriptions given above with reference to FIGS. 6 to 9B may be applied to the present embodiment. In an embodiment, bottom metal contacts BMC0a and BMCOb' respectively electrically connected to first and second pass transistors PTRO and PTR1 may be adjacent to each other in the first direction Y. As described above, the bottom metal contacts BMC0a and BMCOb' may be disposed in a structure which does not face each other. For example, the first pass transistor PTRO may include a gate terminal GT and a source/drain terminal which is disposed at one side (for example, a right side in the first direction Y) of the gate terminal GT in the first direction Y and is electrically connected to the bottom metal contact BMC0a, and the second pass transistor PTR1 may include a gate terminal GT and a source/drain terminal which is disposed at one side (for example, a right side in the first direction Y) of the gate terminal GT in the first direction Y and is electrically connected to the bottom metal contact BMCOb'. For example, the source/drain terminal electrically connected to the bottom metal contact BMC0a and the source/drain terminal electrically connected to the bottom metal contact BMCOb' might not be adjacent to each other in the first direction Y.

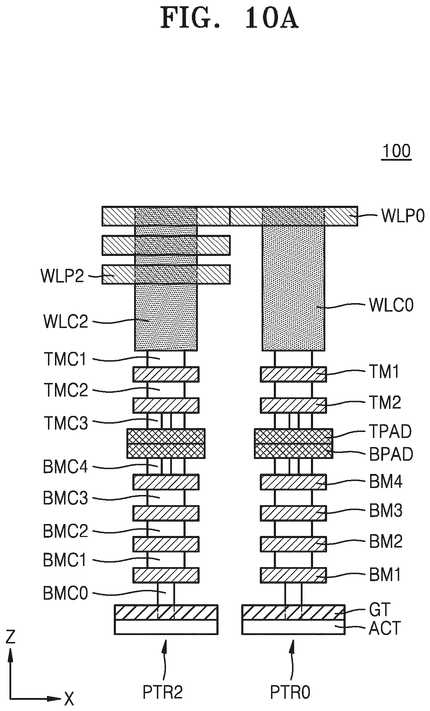

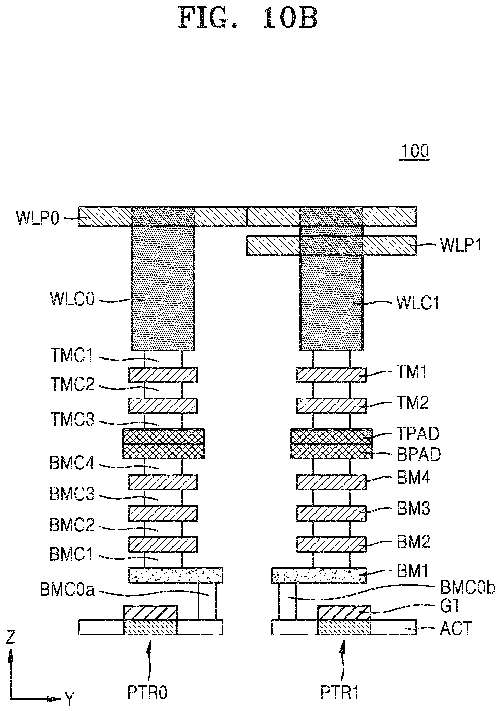

FIG. 10A is a side view of a memory device 100 in a second direction X, according to an embodiment, and FIG. 10B is a side view of the memory device 100 in a first direction Y, according to an embodiment. Referring to FIGS. 10A and 10B, the memory device 100 may correspond to a modification example of the memory device 60 illustrated in FIGS. 9A and 9B, and the descriptions given above with reference to FIGS. 6 to 9C may be applied to the present embodiment.

In an embodiment, at least one of top metal contacts TMC1 to TMC3 of the memory device 100 may include a plurality of metal contacts in the second direction X. For example, the top metal contact TMC3 may be implemented with two top metal contacts TMC3 in the second direction X, and thus, the two top metal contacts TMC3 may be disposed between a corresponding top metal layer TM2 and a corresponding top bonding pad TPAD. In an embodiment, at least one of bottom metal contacts BMCO to BMC4 of the memory device 100 may include a plurality of metal contacts in the second direction X. For example, the bottom metal contact BMC4 may be implemented with two bottom metal contacts BMC4 in the second direction X, and thus, the two bottom metal contacts BMC4 may be disposed between a corresponding bottom bonding pad BPAD and a corresponding bottom metal layer BM4. For example, the two top metal contacts TMC3 and the two bottom metal contacts BMC4 may each be aligned in the vertical direction Z.

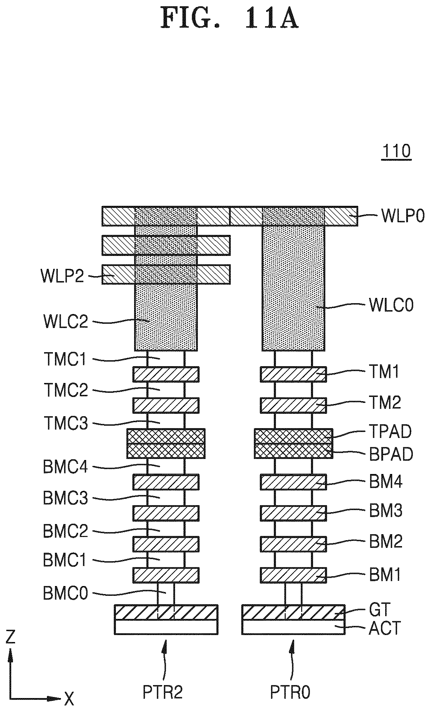

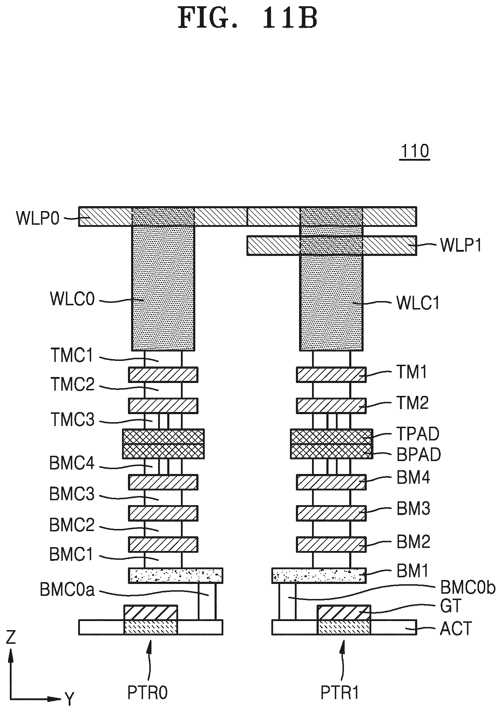

FIG. 11A is a side view of a memory device 110 in a second direction X, according to an embodiment, and FIG. 11B is a side view of the memory device 110 in a first direction Y, according to an embodiment. Referring to FIGS. 11A and 11B, the memory device 110 may correspond to a modification example of the memory device 60 illustrated in FIGS. 9A and 9B, and the descriptions given above with reference to FIGS. 6 to 9C may be applied to the present embodiment.

In an embodiment, at least one of top metal contacts TMC1 to TMC3 of the memory device 110 may include a plurality of metal contacts in the first direction Y. For example, the top metal contact TMC3 may be implemented with two top metal contacts TMC3 in the first direction Y, and thus, the two top metal contacts TMC3 may be disposed between a corresponding top metal layer TM2 and a corresponding top bonding pad TPAD. In an embodiment, at least one of bottom metal contacts BMCO to BMC4 of the memory device 110 may include a plurality of metal contacts in the first direction Y. For example, the bottom metal contact BMC4 may be implemented with two bottom metal contacts BMC4 in the first direction Y, and thus, the two bottom metal contacts BMC4 may be disposed between a corresponding bottom bonding pad BPAD and a corresponding bottom metal layer BML4. For example, the two top metal contacts TMC3 and the two bottom metal contacts BMC4 may each be aligned in the vertical direction Z.

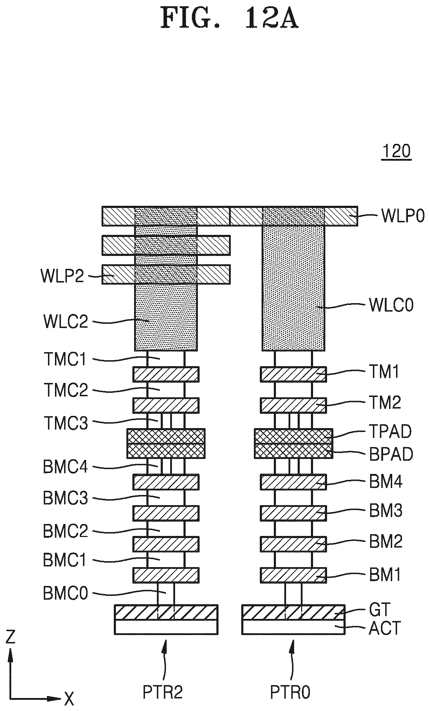

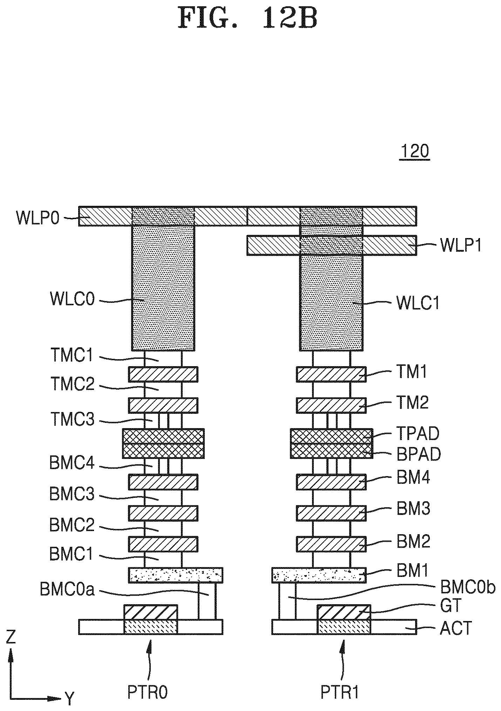

FIG. 12A is a side view of a memory device 120 in a second direction X, according to an embodiment, and FIG. 12B is a side view of the memory device 120 in a first direction Y, according to an embodiment. Referring to FIGS. 12A and 12B, the memory device 120 may correspond to a modification example of the memory device 60 illustrated in FIGS. 9A and 9B, and the descriptions given above with reference to FIGS. 6 to 9C may be applied to the present embodiment.

In an embodiment, at least one of top metal contacts TMC1 to TMC3 of the memory device 120 may include a plurality of metal contacts in the first direction Y and the second direction X. For example, the top metal contact TMC3 may be implemented with two top metal contacts TMC3 in the first direction Y and two top metal contacts TMC3 in the second direction X, and thus, four top metal contacts TMC3 may be disposed between a corresponding top metal layer TM2 and a corresponding top bonding pad TPAD. In an embodiment, at least one of bottom metal contacts BMCO to BMC4 of the memory device 120 may include a plurality of metal contacts in the first direction Y and the second direction X. For example, the bottom metal contact BMC4 may be implemented with two bottom metal contacts BMC4 in the first direction Y and two bottom metal contacts BMC4 in the second direction X, and thus, four bottom metal contacts BMC4 may be disposed between a corresponding bottom bonding pad BPAD and a corresponding bottom metal layer BM4. For example, the two top metal contacts TMC3 and the two bottom metal contacts BMC4 may each be aligned in the vertical direction Z.

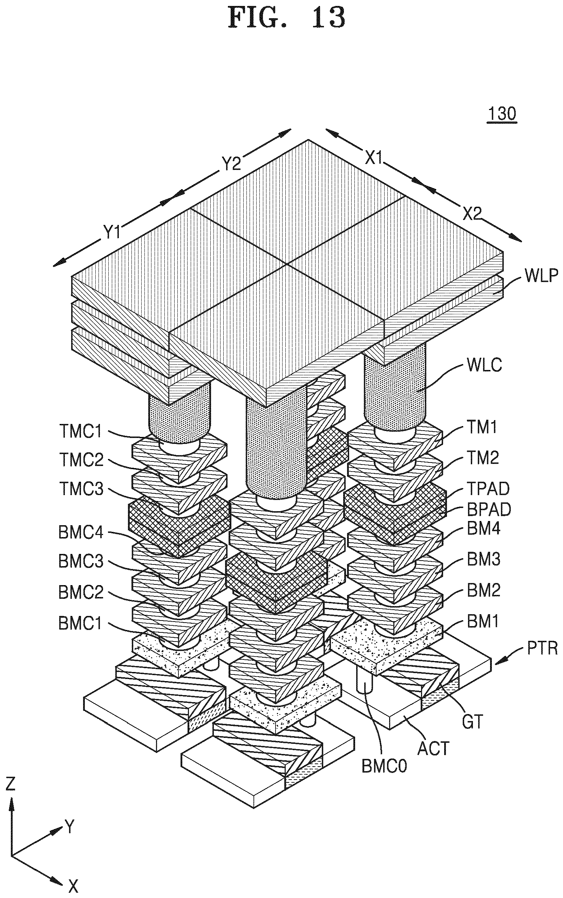

FIG. 13 is a perspective view illustrating a memory device 130 according to an embodiment. Referring to FIG. 13, the memory device 130 may include a plurality of word line pads WLP arranged in a first direction Y and a second direction X and a plurality of word line contacts WLC arranged in the first direction Y and the second direction X. The memory device 130 may correspond to a modification example of the memory device 60 illustrated in FIG. 6, and to the extent that a detailed description of an element has been omitted, it may be assumed that the element may be at least similar to a corresponding element that has been described elsewhere within the present disclosure. In an embodiment, each word line contact WLC may extend in a vertical direction Z from a corresponding word line pad WLP and may be electrically connected to a corresponding top metal contact TMC1. Therefore, heights of a plurality of word line contacts WLC may differ from one another in the vertical direction Z.

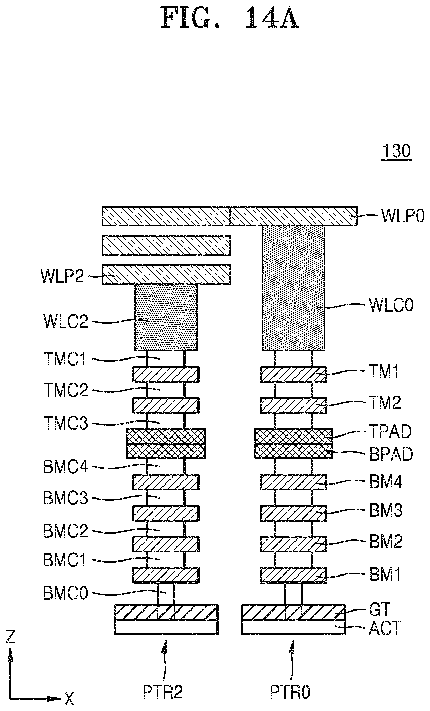

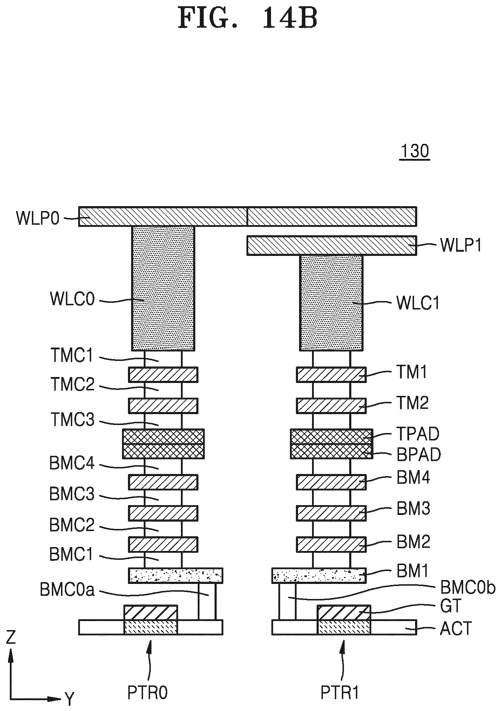

FIG. 14A is a side view of the memory device 130 of FIG. 13 in a second direction X, according to an embodiment, and FIG. 14B is a side view of the memory device 130 of FIG. 13 in a first direction Y, according to an embodiment. Referring to FIGS. 14A and 14B, first and second word line contacts WLC0 and WLC1 adjacent to each other in the first direction Y may have different heights in a vertical direction Z, and first and third word line contacts WLC0 and WLC2 adjacent to each other in the second direction X may have different heights in the vertical direction Z. The first word line contact WLC0 may extend in the vertical direction Z from a first word line pad WLP0, the second word line contact WLC1 may extend in the vertical direction Z from the second word line pad WLP1, and the third word line contact WLC2 may extend in the vertical direction Z from the third word line pad WLP2.

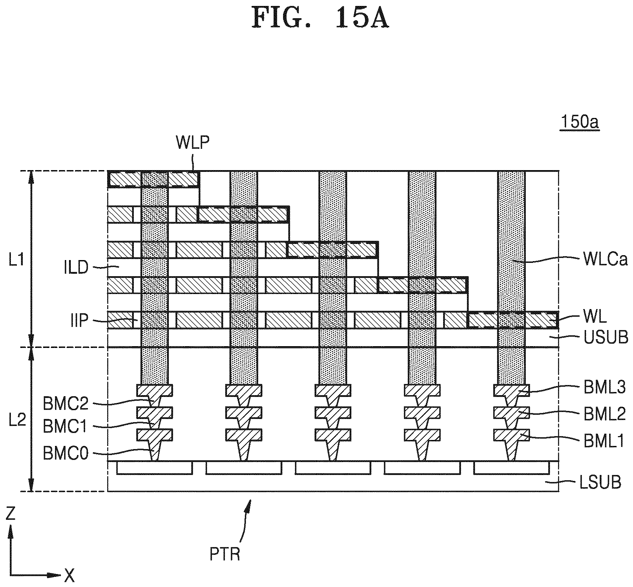

FIG. 15A is a cross-sectional view illustrating a memory device 150a according to an embodiment. Referring to FIG. 15A, the memory device 150a may have a COP structure including a first semiconductor layer L1 and a second semiconductor layer L2. The second semiconductor layer L2 may include a plurality of pass transistors PTR disposed in a lower substrate LSUB, and the first semiconductor layer L1 may include a plurality of word lines WL which are stacked on an upper substrate USUB in a vertical direction Z and extend in a second direction X. An interlayer insulation layer ILD may be disposed between word lines WL adjacent to each other in the vertical direction Z.

The memory device 150a may include a plurality of word line contacts WLCa each extending in the vertical direction Z. A region where each word line WL is electrically connected to each word line contact WLCa may be defined as a word line pad WLP. For example, the plurality of word line contacts WLCa may have the same height in the vertical direction Z. The plurality of word line contacts WLCa may pass through the plurality of word lines WL and may be electrically connected to a bottom metal layer BML3. Each word line contact WLCa may be electrically connected to an active area (for example, a drain area) of the pass transistor PTR through a plurality of bottom metal layers BML1 to BML3 and a plurality of bottom metal contacts BMCO to BMC2.

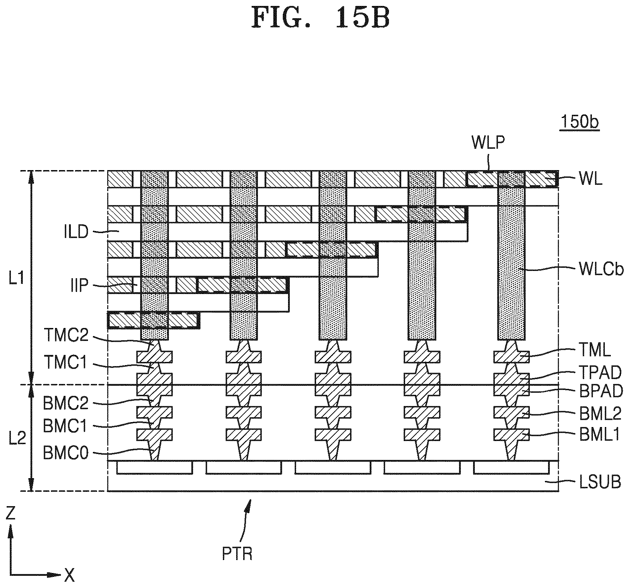

FIG. 15B is a cross-sectional view illustrating a memory device 150b according to an embodiment. Referring to FIG. 15B, the memory device 150b may have a B-VNAND structure including a first semiconductor layer L1 and a second semiconductor layer L2. The second semiconductor layer L2 may include a plurality of pass transistors PTR disposed in a lower substrate LSUB, and the first semiconductor layer L1 may include a plurality of word lines WL which are stacked in a vertical direction Z and extend in a second direction X. An interlayer insulation layer ILD may be disposed between word lines WL adjacent to each other in the vertical direction Z.

The memory device 150b may include a plurality of word line contacts WLCb each extending in the vertical direction Z. A region where each word line WL is electrically connected to each word line contact WLCb may be defined as a word line pad WLP. For example, the plurality of word line contacts WLCb may have the same height in the vertical direction Z. The plurality of word line contacts WLCb may pass through the plurality of word lines WL and may be electrically connected to a top metal contact TMC2. Each word line contact WLCb may be electrically connected to an active area of the pass transistor PTR through a plurality of top metal contacts TMC1 and TMC2, a top metal layer TML, a top bonding pad TPAD, a bottom bonding pad BPAD, a plurality of bottom metal layers BML1 and BML2, and a plurality of bottom metal contacts BMCO to BMC2.

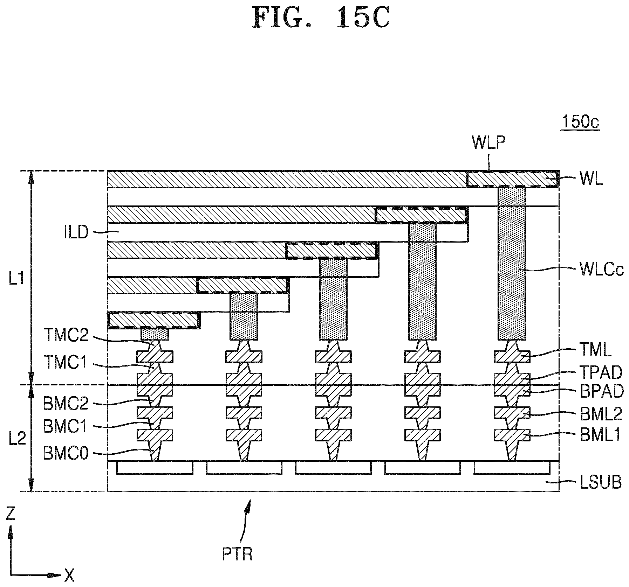

FIG. 15C is a cross-sectional view illustrating a memory device 150c according to an embodiment. Referring to FIG. 15C, the memory device 150c may have a B-VNAND structure including a first semiconductor layer L1 and a second semiconductor layer L2. The second semiconductor layer L2 may include a plurality of pass transistors PTR disposed in a lower substrate LSUB, and the first semiconductor layer L1 may include a plurality of word lines WL which are stacked in a vertical direction Z and extend in a second direction X. An interlayer insulation layer ILD may be disposed between word lines WL adjacent to each other in the vertical direction Z.

The memory device 150c may include a plurality of word line contacts WLCc each extending in the vertical direction Z. A region where each word line WL is electrically connected to each word line contact WLCc may be defined as a word line pad WLP. For example, the plurality of word line contacts WLCc may have different heights in the vertical direction Z. Each word line contact WLCc may be disposed between a corresponding word line pad WLP and a corresponding top metal contact TMC2. Each word line contact WLCc may be electrically connected to an active area of the pass transistor PTR through a plurality of top metal contacts TMC1 and TMC2, a top metal layer TML, a top bonding pad TPAD, a bottom bonding pad BPAD, a plurality of bottom metal layers BML1 and BML2, and a plurality of bottom metal contacts BMCO to BMC2.

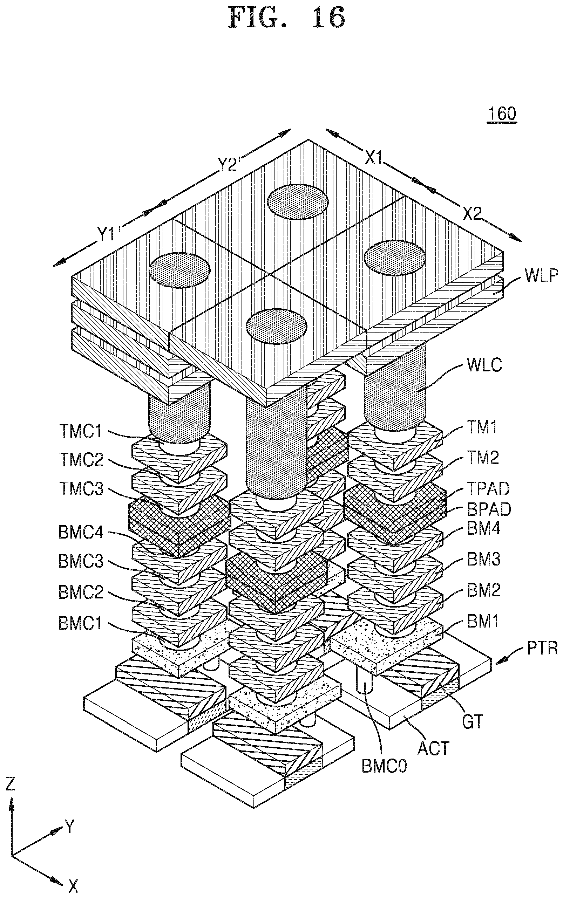

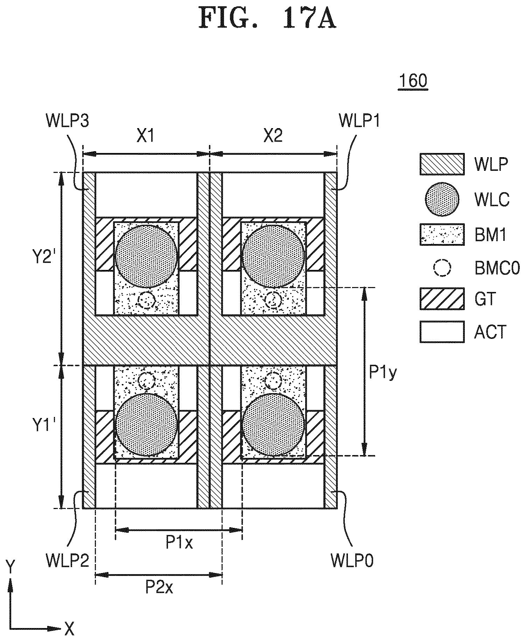

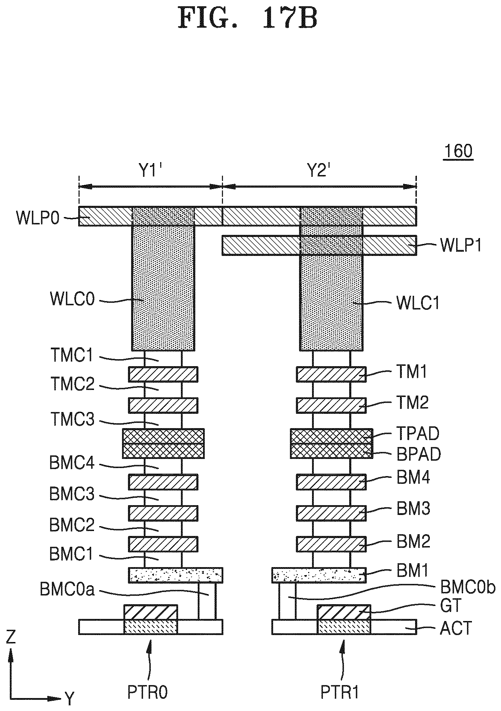

FIG. 16 is a perspective view illustrating a memory device 160 according to an embodiment. FIG. 17A is a plan view of the memory device 160 of FIG. 16 according to an embodiment, and FIG. 17B is a side view of the memory device 160 of FIG. 16 according to an embodiment.

Referring to FIGS. 16 to 17B, the memory device 160 may correspond to a modification example of the memory device 60 illustrated in FIG. 6, and to the extent that a detailed description of an element has been omitted, it may be assumed that the element may be at least similar to a corresponding element that has been described elsewhere within the present disclosure. The memory device 160 may include first to fourth word line pads WLP0 to WLP3 arranged in a first direction Y and a second direction X. The first and second word line pads WLP0 and WLP1 adjacent to each other in the first direction Y may have different widths in the first direction Y. For example, the first word line pad WLP0 may have a first width Y1' in the first direction Y, the second word line pad WLP1 may have a second width Y2' in the first direction Y, and the first width Y1' may differ from the second width Y2'. The first and third word line pads WLP0 and WLP2 adjacent to each other in the second direction X may have the same width in the second direction X. For example, the third word line pad WLP2 may have a first width X1 in the second direction X, the first word line pad WLP0 may have a second width X2 in the second direction X, and the first width X1 may be equal to the second width X2.

In an embodiment, the word line contacts WLC may have a first pitch P1x in the second direction X, and the pass transistor PTR may have a second pitch P2x in the second direction X. In this case, the first pitch P1x and the second pitch P2x may be equal to one another. For example, the first and second pitches P1x and P2x may be equal to the first and second widths X1 and X2. As described above, in the memory device 160, pitches of word line pads WLP, word line contacts WLC, and pass transistors PTR adjacent to one another in the second direction X may be equal to one another.

In an embodiment, the word line contacts WLC may have a first pitch P1y in the first direction Y. For example, the first pitch P1y may be equal to the first and second widths Y1' and Y2'. As described above, in the memory device 160, even when the word line pads WLP have different widths in the first direction Y, the word line contacts WLC may be arranged at the same pitch P1y in the first direction Y. Therefore, a center of the first word line contact WLC0 may be aligned with a center of the first word line pad WLP0 in the first direction Y, but a center of the second word line contact WLC1 might not be aligned with a center of the second word line pad WLP1 in the first direction Y. Accordingly, the center of the second word line contact WLC1 may be inclined from the center of the second word line pad WLP1 from one side (for example, a right side) thereof. The pass transistors PTR may have the same pitch in the first direction Y.

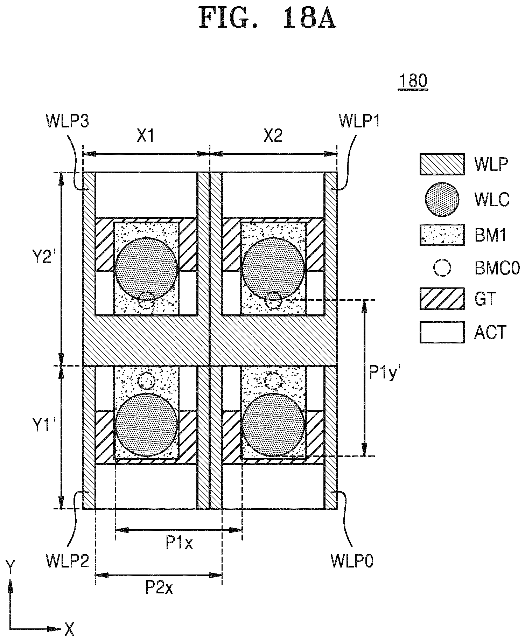

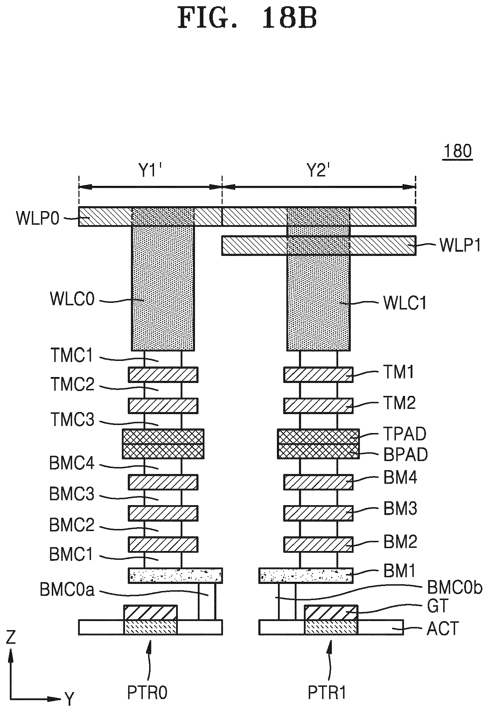

FIG. 18A is a plan view of a memory device 180 according to an embodiment, and FIG. 18B is a side view of the memory device 180 of FIG. 18A according to an embodiment. Referring to FIGS. 18A and 18B, the memory device 180 may correspond to a modification example of the memory device 160 illustrated in FIG. 16, and to the extent that a detailed description of an element has been omitted, it may be assumed that the element may be at least similar to a corresponding element that has been described elsewhere within the present disclosure. In the memory device 180, first and second word line pads WLP0 and WLP1 adjacent to each other in the first direction Y may have different widths in the first direction Y, and word line contacts WLC may be arranged at a center of a word line pad WLP in the first direction Y. Therefore, the word line contacts WLC might not have a constant pitch. Therefore, a center of a first word line contact WLC0 may be aligned with a center of the first word line pad WLP0 in the first direction Y, and moreover, a center of a second word line contact WLC 1 may be aligned with a center of the second word line pad WLP1 in the first direction Y.

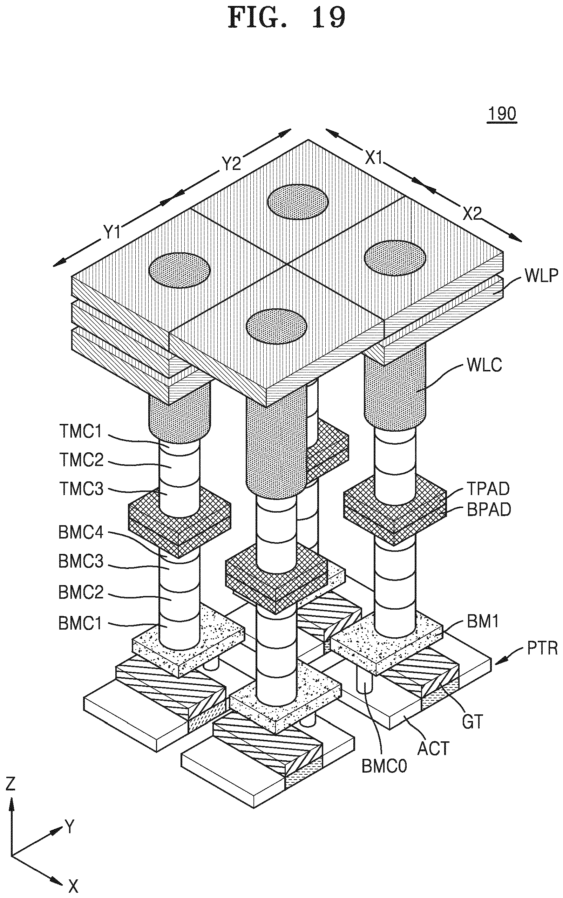

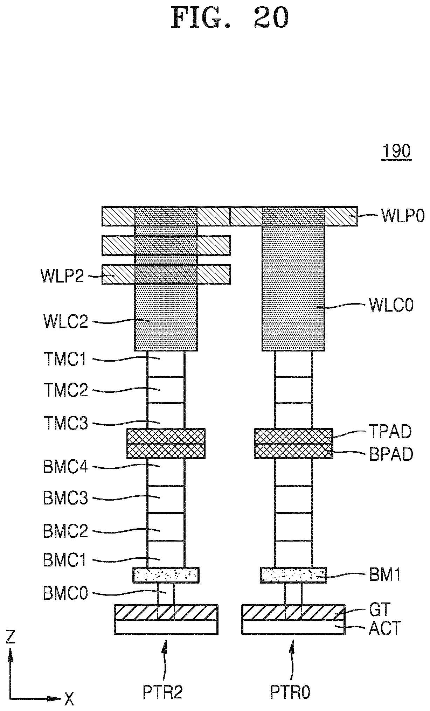

FIG. 19 is a perspective view illustrating a memory device 190 according to an embodiment, and FIG. 20 is a side view of the memory device 190 of FIG. 19 according to an embodiment. Referring to FIGS. 19 and 20, the memory device 190 may correspond to a modification example of the memory device 60 illustrated in FIG. 6, and to the extent that a detailed description of an element has been omitted, it may be assumed that the element may be at least similar to a corresponding element that has been described elsewhere within the present disclosure. In the memory device 190, each word line pad WLP may be electrically connected to each word line contact WLC, and each word line contact WLC may be electrically connected to a corresponding pass transistor PTR through a plurality of top metal contacts TMC1 to TMC3, a top bonding pad TPAD, a bottom bonding pad BPAD, and a plurality of bottom metal contacts BMCO to BMC4. As described above, according to an embodiment, top metal layers and/or bottom metal layers might not be disposed between each word line contact WLC and a corresponding pass transistor PTR. In this case, the number of top metal contacts TMC1 to TMC3 may be variously changed, and moreover, the number of bottom metal contacts BMCO to BMC4 may be variously changed.

However, the inventive concept is not necessarily limited thereto, and in some embodiments, each word line contact WLC may be electrically connected to a corresponding pass transistor PTR through the plurality of top metal contacts TMC1 to TMC3, a plurality of top metal layers TML1 and TML2, the top bonding pad TPAD, the bottom bonding pad BPAD, and the plurality of bottom metal contacts BMCO to BMC4. In some embodiments, each word line contact WLC may be electrically connected to a corresponding pass transistor PTR through the plurality of top metal contacts TMC1 to TMC3, the top bonding pad TPAD, the bottom bonding pad BPAD, a plurality of bottom metal layers BML1 and BML2, and the plurality of bottom metal contacts BMCO to BMC4.

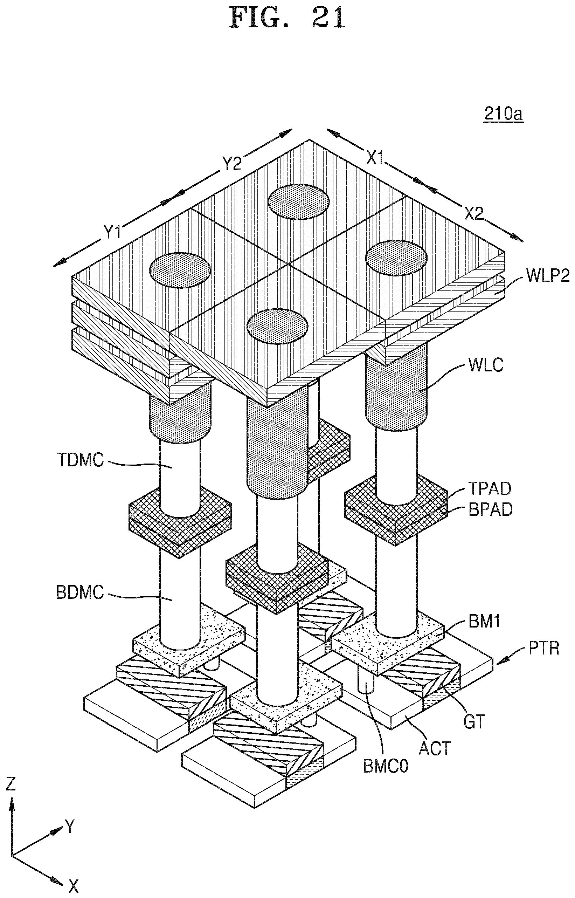

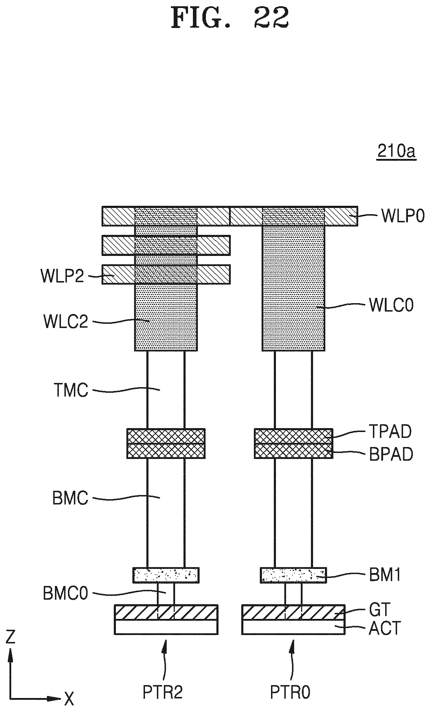

FIG. 21 is a perspective view illustrating a memory device 210a according to an embodiment, and FIG. 22 is a side view of the memory device 210a of FIG. 21 according to an embodiment. Referring to FIGS. 21 and 22, the memory device 210a may correspond to a modification example of the memory device 60 illustrated in FIG. 6, and to the extent that a detailed description of an element has been omitted, it may be assumed that the element may be at least similar to a corresponding element that has been described elsewhere within the present disclosure. In the memory device 210a, each word line pad WLP may be electrically connected to each word line contact WLC, and each word line contact WLC may be electrically connected to a corresponding pass transistor PTR through an upper direct metal contact TDMC, a top bonding pad TPAD, a bottom bonding pad BPAD, and a lower direct metal contact BDMC. As described above, according to an embodiment, top metal layers and/or bottom metal layers might not be disposed between each word line contact WLC and a corresponding pass transistor PTR, the upper direct metal contact TDMC may be implemented as a single direct contact, and the lower direct metal contact BDMC may also be implemented as a single direct contact.

However, the inventive concept is not necessarily limited thereto, and in some embodiments, each word line contact WLC may be electrically connected to a corresponding pass transistor PTR through the upper direct metal contact TDMC, the top bonding pad TPAD, and a plurality of bottom metal contacts BMCO to BMC4. In this case, at least one bottom metal layer may be disposed between the plurality of bottom metal contacts BMCO to BMC4. In some embodiments, each word line contact WLC may be electrically connected to a corresponding pass transistor PTR through a plurality of top metal contacts TMC1 to TMC3, the top bonding pad TPAD, the bottom bonding pad BPAD, and the lower direct metal contact BDMC, and in this case, at least one top metal layer may be disposed between the plurality of top metal contacts TMC1 to TMC3.

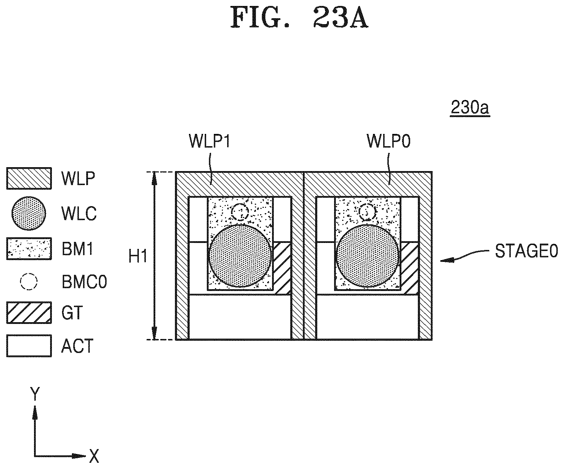

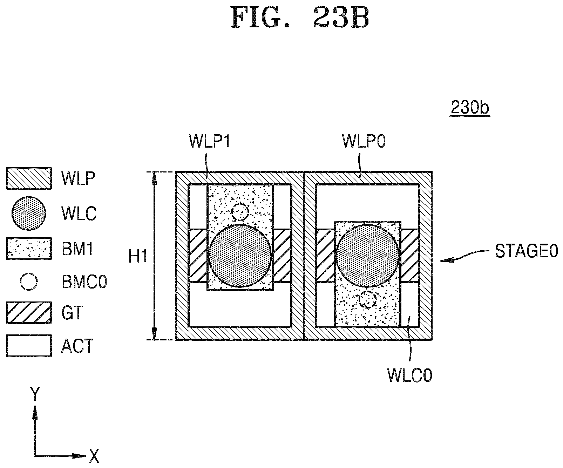

FIGS. 23A and 23B illustrate a connection structure between a word line pad and a pass transistor arranged at one stage, according to some embodiments. In FIGS. 23A and 23B, a memory block may have a first height H1 in a first direction Y.

Referring to FIG. 23A, a memory device 230a, according to an embodiment, may include first and second word line pads WLP0 and WLP1 which are arranged at one stage, based on the first height H1. For example, an active area ACT of a pass transistor may be disposed adjacent to a lower edge region of each of corresponding first and second word line pads WLP0 and WLP1. Each of the first and second word line pads WLP0 and WLP1 may be electrically connected to an active area ACT of a corresponding pass transistor through a corresponding word line contact WLC, a corresponding bottom metal layer BM1, and a corresponding bottom metal contact BMCO. For example, the bottom metal contact BMCO corresponding to each of the first and second word line pads WLP0 and WLP1 may be disposed adjacent thereto in a second direction X.

Referring to FIG. 23B, a memory device 230b, according to an embodiment, may include first and second word line pads WLP0 and WLP1 which are arranged at one stage, based on the first height H1. For example, an active area ACT of a pass transistor may be disposed adjacent to a center region of each of corresponding first and second word line pads WLP0 and WLP1. Each of the first and second word line pads WLP0 and WLP1 may be electrically connected to an active area ACT of a corresponding pass transistor through a corresponding word line contact WLC, a corresponding bottom metal layer BM1, and a corresponding bottom metal contact BMCO. For example, the bottom metal contact BMCO corresponding to the first word line pad WLP0 may be disposed on a corresponding gate terminal GT, and the bottom metal contact BMCO corresponding to the second word line pad WLP1 may be disposed below a corresponding gate terminal GT.

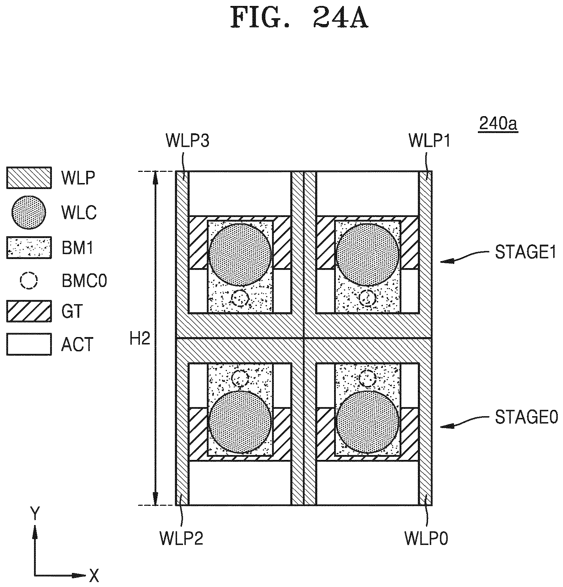

FIGS. 24A to 24D illustrate a connection structure between a word line pad and a pass transistor arranged at two stages, according to some embodiments. In FIGS. 24A to 24D, a memory block may have a second height H2 in a first direction Y.

Referring to FIG. 24A, a memory device 240a according to an embodiment may include first to fourth word line pads WLP0 to WLP3 which are arranged at two stages, based on the second height H2. For example, an active area ACT of each of pass transistors of a first stage STAGEO may be disposed adjacent to a lower edge region of each of corresponding first and third word line pads WLP0 and WLP2, and an active area ACT of each of pass transistors of a second stage STAGE1 may be disposed adjacent to an upper edge region of each of corresponding second and fourth word line pads WLP1 and WLP3. For example, bottom metal contacts BMCO respectively electrically connected to the first and third word line pads WLP0 and WLP2 of the first stage STAGEO may be disposed at one side (for example, at an upper end in a first direction Y) of a corresponding gate terminal GT in the first direction Y, and bottom metal contacts BMCO respectively electrically connected to the second and fourth word line pads WLP1 and WLP3 of the second stage STAGE1 may be disposed at one side (for example, at a lower end in the first direction Y) of a corresponding gate terminal GT in the first direction Y.

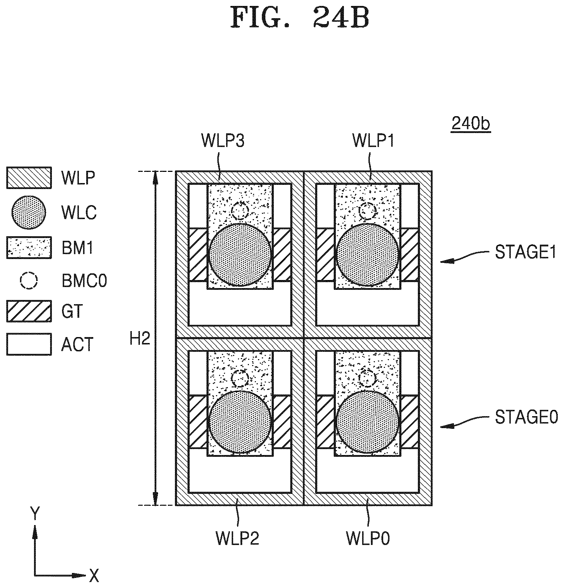

Referring to FIG. 24B, a memory device 240b, according to an embodiment, may include first to fourth word line pads WLP0 to WLP3 which are arranged at two stages, based on the second height H2. For example, an active area ACT of each of pass transistors may be disposed adjacent to a center region of each of corresponding first to fourth word line pads WLP0 to WLP3. For example, bottom metal contacts BMCO respectively electrically connected to first and third word line pads WLP0 and WLP2 of a first stage STAGEO may be disposed at one side (for example, at an upper end in a first direction Y) of a corresponding gate terminal GT in the first direction Y, and bottom metal contacts BMCO respectively electrically connected to second and fourth word line pads WLP1 and WLP3 of a second stage STAGE1 may be disposed at one side (for example, at an upper end in the first direction Y) of a corresponding gate terminal GT in the first direction Y.

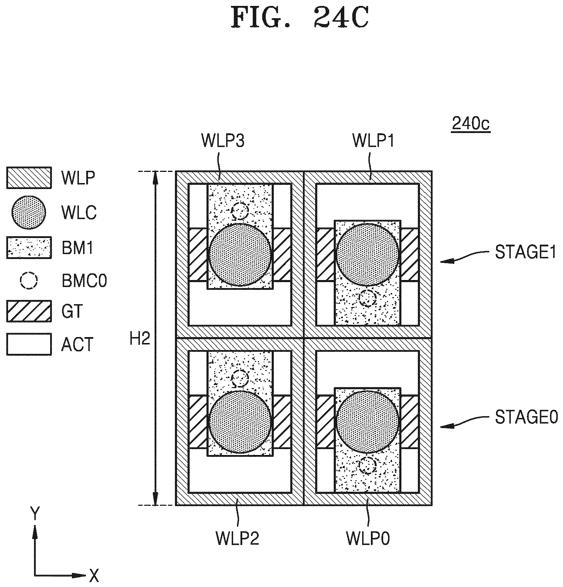

Referring to FIG. 24C, a memory device 240c, according to an embodiment, may include first to fourth word line pads WLP0 to WLP3 which are arranged at two stages, based on the second height H2. For example, an active area ACT of each of pass transistors may be disposed adjacent to a center region of each of corresponding first to fourth word line pads WLP0 to WLP3. For example, bottom metal contacts BMCO respectively electrically connected to the first and second word line pads WLP0 and WLP1 may be disposed at one side (for example, at a lower end in a first direction Y) of a corresponding gate terminal GT in the first direction Y, and bottom metal contacts BMCO respectively electrically connected to the third and fourth word line pads WLP2 and WLP3 may be disposed at one side (for example, at an upper end in the first direction Y) of a corresponding gate terminal GT in the first direction Y.

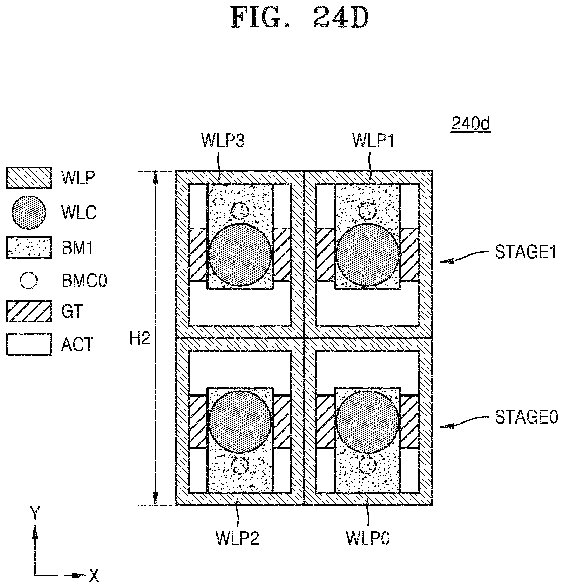

Referring to FIG. 24D, a memory device 240d, according to an embodiment, may include first to fourth word line pads WLP0 to WLP3 which are arranged at two stages, based on the second height H2. For example, an active area ACT of each of pass transistors may be disposed adjacent to a center region of each of corresponding first to fourth word line pads WLP0 to WLP3. For example, bottom metal contacts BMCO respectively electrically connected to first and third word line pads WLP0 and WLP2 of a first stage STAGEO may be disposed at one side (for example, at a lower end in a first direction Y) of a corresponding gate terminal GT in the first direction Y, and bottom metal contacts BMCO respectively electrically connected to second and fourth word line pads WLP1 and WLP3 of a second stage STAGE1 may be disposed at one side (for example, at an upper end in the first direction Y) of a corresponding gate terminal GT in the first direction Y.

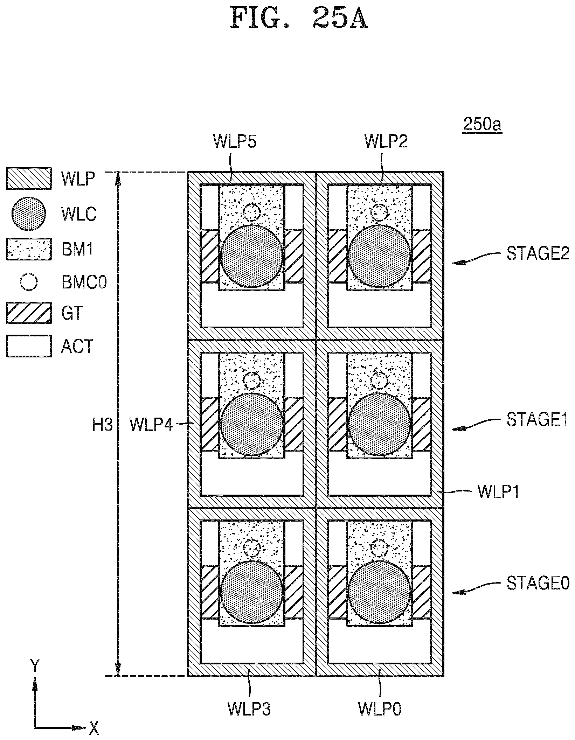

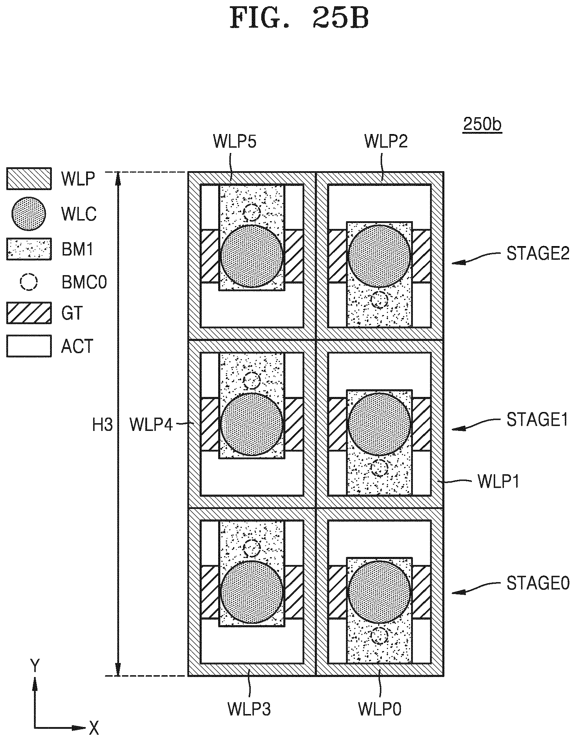

FIGS. 25A and 25B illustrate a connection structure between a word line pad and a pass transistor arranged at three stages, according to some embodiments. In FIGS. 25A and 25B, a memory block may have a third height H3 in a first direction Y.

Referring to FIG. 25A, a memory device 250a, according to an embodiment, may include first to sixth word line pads WLP0 to WLP5 which are arranged at three stages, based on the third height H3. For example, active areas ACT of pass transistors of first to third stages STAGEO to STAGE2 may be respectively disposed at center regions of corresponding first to sixth word line pads WLP0 to WLP5. For example, a bottom metal contact BMCO electrically connected to each of the first to sixth word line pads WLP0 to WLP5 of the first to third stages STAGEO to STAGE2 may be disposed at one side (for example, at an upper end in a first direction Y) of a corresponding gate terminal GT in the first direction Y.

Referring to FIG. 25B, a memory device 250b according to an embodiment may include first to sixth word line pads WLP0 to WLP5 which are arranged at three stages, based on the third height H3. For example, active areas ACT of pass transistors may be respectively disposed at center regions of corresponding first to sixth word line pads WLP0 to WLP5. For example, bottom metal contacts BMCO respectively electrically connected to the first to third word line pads WLP0 to WLP2 may be disposed at one side (for example, at a lower end in a first direction Y) of a corresponding gate terminal GT in the first direction Y, and bottom metal contacts BMCO respectively electrically connected to the fourth to sixth word line pads WLP3 to WLP5 may be disposed at one side (for example, at an upper end in the first direction Y) of a corresponding gate terminal GT in the first direction Y.

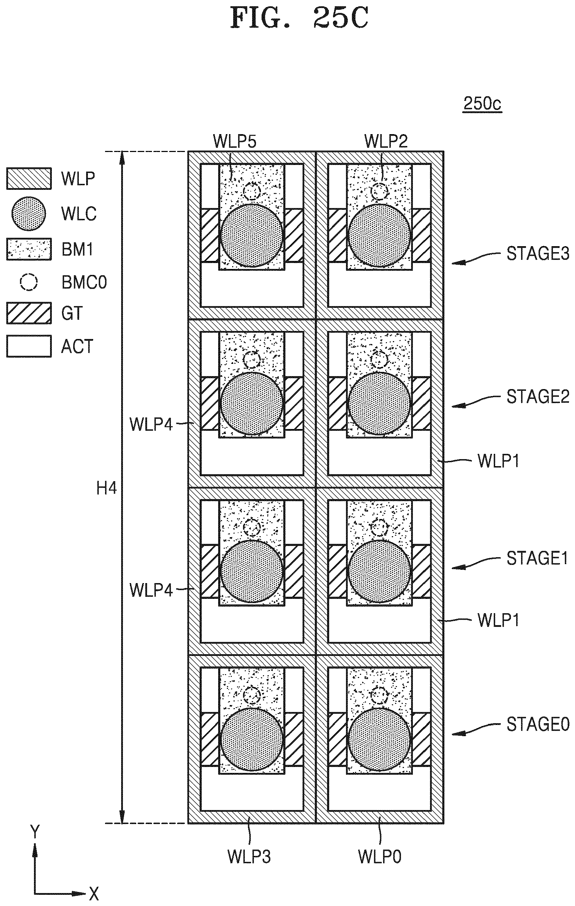

FIG. 25C illustrates a connection structure between a word line pad and a pass transistor arranged at four stages, according to an embodiment. In FIG. 25C, a memory block may have a fourth height H4 in a first direction Y. A memory device 250c may include first to eighth word line pads WLP0 to WLP7 which are arranged at four stages, based on the fourth height H4. For example, active areas ACT of pass transistors of first to fourth stages STAGEO to STAGE3 may be respectively disposed at center regions of corresponding first to eighth word line pads WLP0 to WLP7. For example, a bottom metal contact BMCO electrically connected to each of the first to eighth word line pads WLP0 to WLP7 of the first to fourth stages STAGEO to STAGE3 may be disposed at one side (for example, at an upper end in a first direction Y) of a corresponding gate terminal GT in the first direction Y.

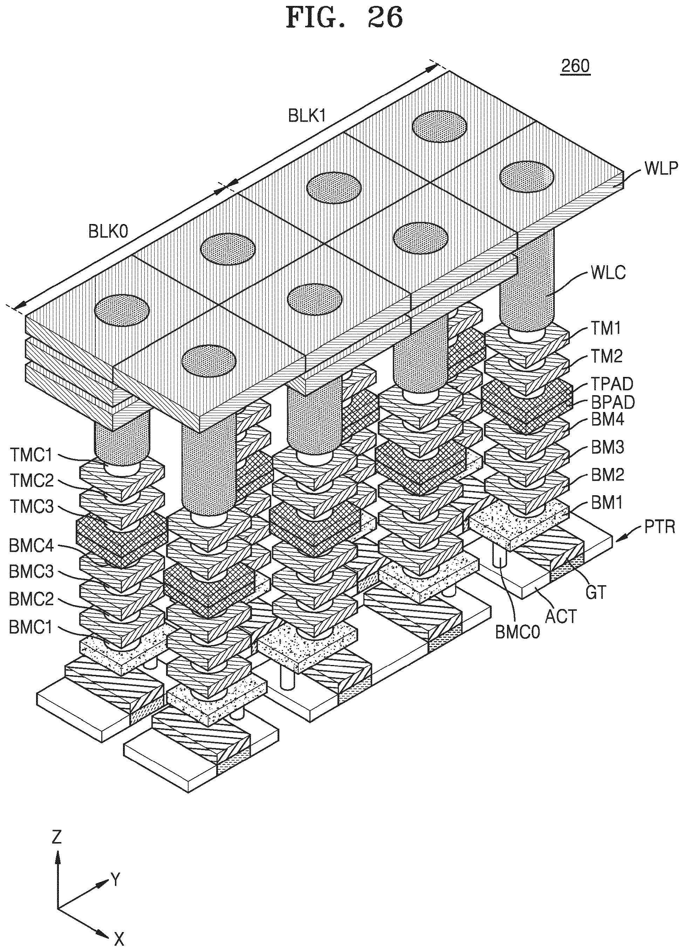

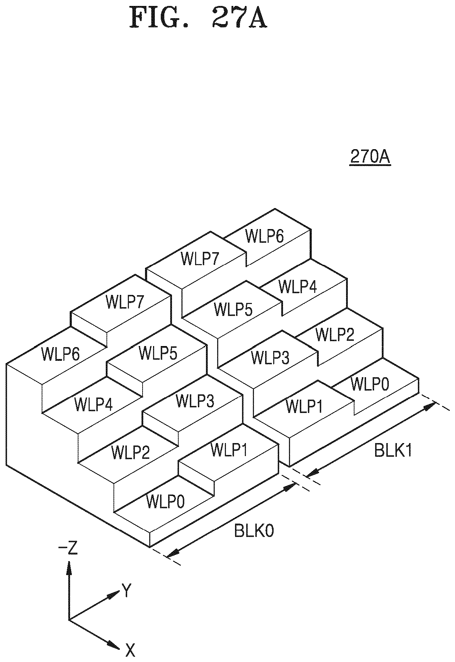

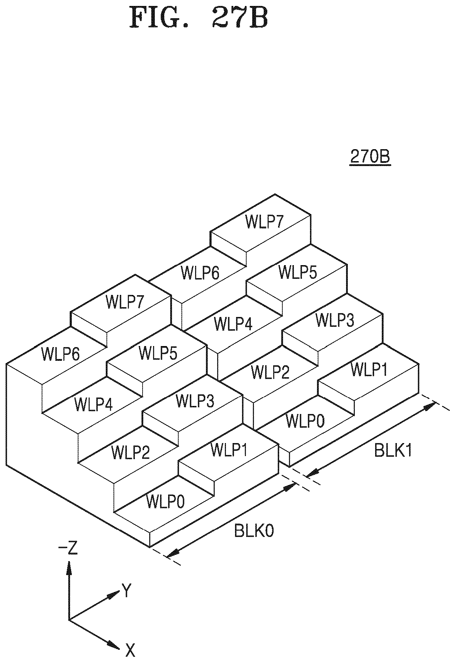

FIG. 26 is a perspective view illustrating a memory device 260 according to an embodiment. Referring to FIG. 26, the memory device 260 may include a plurality of word line pads WLP, a plurality of word line contacts WLC, and a plurality of pass transistors PTR, which correspond to first and second memory blocks BLKO and BLK1. The first and second memory blocks BLKO and BLK1 may be adjacent to each other in a first direction Y, the first memory block BLKO may be referred to as a "lower memory block", and the second memory block BLK1 may be referred to as an "upper memory block". The plurality of word line pads WLP may be implemented in a stair shape. For example, the plurality of word line pads WLP may be formed by an SDP process. Hereinafter, a word line pad structure will be described in more detail with reference to FIGS. 27A and 27B.

FIG. 27A illustrates a word line pad structure 270A according to an embodiment. Referring to FIG. 27A, the word line pad structure 270A may be formed by a 2-SDP process, and thus, may include two word line pads having different heights in a first direction Y and four word line pads having different heights in a second direction X, based on each of first and second memory blocks BLKO and BLK1. For example, in each of the first and second memory blocks BLKO and BLK1, word line pads WLP0 and WLP1 may be adjacent to each other in the first direction Y, and word line pads WLP0, WLP2, WLP4 and WLP6 may be adjacent to each other in the second direction X. For example, word line pads (for example, WLP1) may have the same height at a boundary between the first and second memory blocks BLKO and BLK1. As described above, word line pads corresponding to the first memory block BLKO and word line pads corresponding to the second memory block BLK1 may be formed with mirror symmetry.

FIG. 27B illustrates a word line pad structure 270B according to an embodiment. Referring to FIG. 27B, the word line pad structure 270B may be formed by a 2-SDP process, and thus, may include two word line pads having different heights in a first direction Y and four word line pads having different heights in a second direction X, based on each of first and second memory blocks BLKO and BLK1. For example, in each of the first and second memory blocks BLKO and BLK1, word line pads WLP0 and WLP1 may be adjacent to each other in the first direction Y, and word line pads WLP0, WLP2, WLP4 and WLP6 may be adjacent to each other in the second direction X. For example, word line pads (for example, WLP0 and WLP1) may have different heights at a boundary between the first and second memory blocks BLKO and BLK1. As described above, word line pads corresponding to the first memory block BLKO and word line pads corresponding to the second memory block BLK1 may be formed as a shift type.

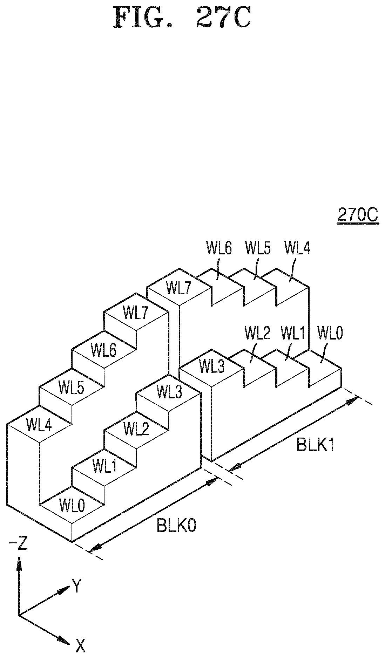

FIG. 27C illustrates a word line pad structure 270C according to an embodiment. Referring to FIG. 27C, the word line pad structure 270C may be formed by a 4-SDP process, and thus, may include four word line pads having different heights in a first direction Y and two word line pads having different heights in a second direction X, based on each of first and second memory blocks BLKO and BLK1. As described above, word line pads corresponding to the first memory block BLKO and word line pads corresponding to the second memory block BLK1 may be formed with mirror symmetry.

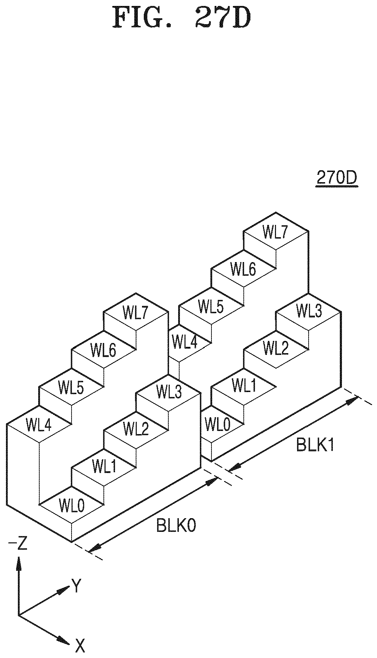

FIG. 27D illustrates a word line pad structure 270D according to an embodiment. Referring to FIG. 27D, the word line pad structure 270D may be formed by a 4-SDP process, and thus, may include four word line pads having different heights in a first direction Y and two word line pads having different heights in a second direction X, based on each of first and second memory blocks BLKO and BLK1. In this case, word line pads corresponding to the first memory block BLKO and word line pads corresponding to the second memory block BLK1 may be formed as a shift type.

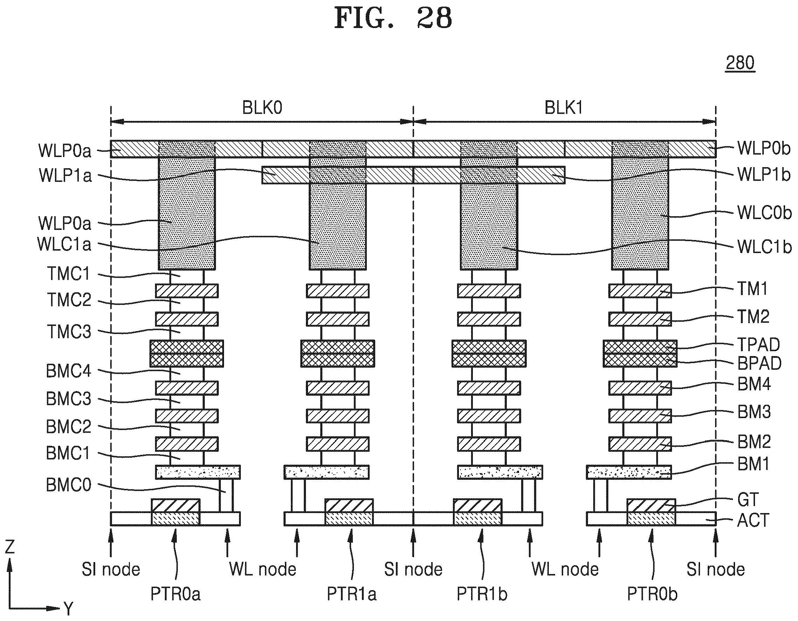

FIG. 28 is a side view illustrating a memory device 280 according to an embodiment. Referring to FIGS. 26 and 28, word line pads WLP0a and WLP1a corresponding to a first memory block BLKO may be arranged at two stages in a first direction Y, and word line pads WLP0a and WLP1a adjacent to each other in the first direction Y may have different heights in a vertical direction Z. Likewise, word line pads WLP0b and WLP1b corresponding to a second memory block BLK1 may be arranged at two stages in the first direction Y, and word line pads WLP0b and WLP1b adjacent to each other in the first direction Y may have different heights in the vertical direction Z. For example, the word line pads WLP0a and WLP1a corresponding to the first memory block BLKO and the word line pads WLP0b and WLP1b corresponding to the second memory block BLK1 may be formed with mirror symmetry, and thus, heights of adjacent word line pads WLP1a and WLP1b may be equal at a boundary between the first and second memory blocks BLKO and BLK1.

A right side of a gate terminal GT of a pass transistor PTR0a may correspond to a word line node (for example, WLO of BLKO of FIG. 4), and a left side of the gate terminal GT may correspond to a driving signal line node (for example, SI0 of FIG. 4). For example, the pass transistor PTR0a may correspond to the pass transistor 1212 of FIG. 4. A left side of a gate terminal GT of a pass transistor PTR1a may correspond to a word line node (for example, WL1 of BLKO of FIG. 4), and a right side of the gate terminal GT may correspond to a driving signal line node (for example, SI1 of FIG. 4). For example, the pass transistor PTR1a may correspond to the pass transistor 1213 of FIG. 4.

A right side of a gate terminal GT of a pass transistor PTR1b may correspond to a word line node (for example, WL1 of BLK1 of FIG. 4), and a left side of the gate terminal GT may correspond to a driving signal line node (for example, SI1 of FIG. 4). For example, the pass transistor PTR1b may correspond to the pass transistor 1223 of FIG. 4. In this case, the pass transistors PTR1a and PTR1b may share an active area, and thus, may share a driving signal line node (for example, SI1 of FIG. 4). A left side of a gate terminal GT of a pass transistor PTR0b may correspond to a word line node (for example, WLO of BLK1 of FIG. 4), and a right side of the gate terminal GT may correspond to a driving signal line node (for example, SI0 of FIG. 4). For example, the pass transistor PTR0b may correspond to the pass transistor 1222 of FIG. 4.

In an embodiment, widths of the word line pads WLP0a and WLP1a corresponding to the first memory block BLKO in the first direction Y may be equal, and widths of the word line pads WLP0b and WLP1b corresponding to the second memory block BLK1 in the first direction Y may be equal to one another. However, the inventive concept is not necessarily limited thereto, and in an embodiment, the widths of the word line pads WLP0a and WLP1a corresponding to the first memory block BLKO in the first direction Y may be equal, and the widths of the word line pads WLP0b and WLP1b corresponding to the second memory block BLK1 in the first direction Y may differ from one another. Also, in an embodiment, the widths of the word line pads WLP0a and WLP1a corresponding to the first memory block BLKO in the first direction Y may differ from one another, and the widths of the word line pads WLP0b and WLP1b corresponding to the second memory block BLK1 in the first direction Y may be equal to one another. Furthermore, in an embodiment, the widths of the word line pads WLP0a and WLP1a corresponding to the first memory block BLKO in the first direction Y may differ from one another, and the widths of the word line pads WLP0b and WLP1b corresponding to the second memory block BLK1 in the first direction Y may differ from one another. The embodiments described above with reference to FIGS. 16 to 18B may be applied to the present embodiment.

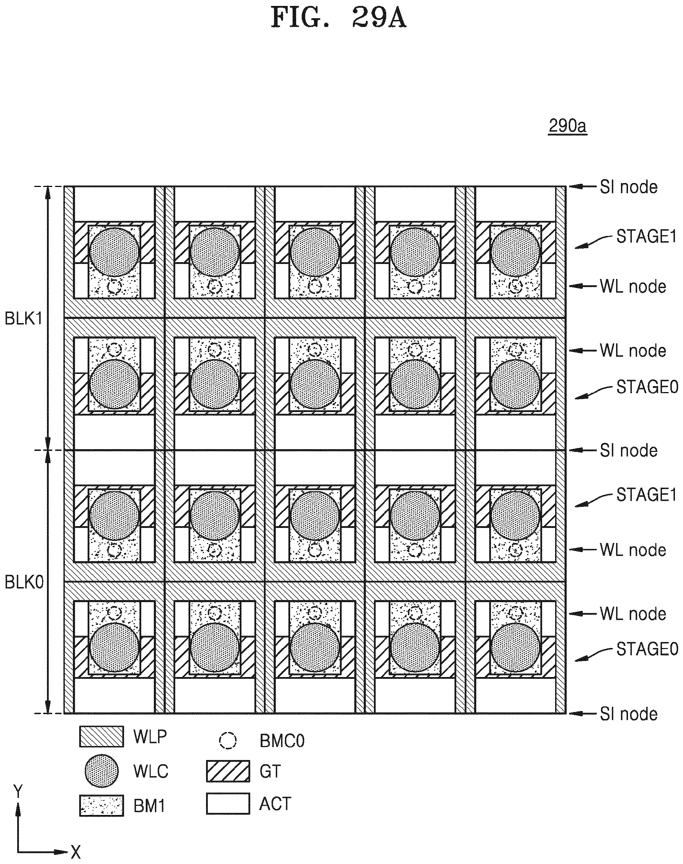

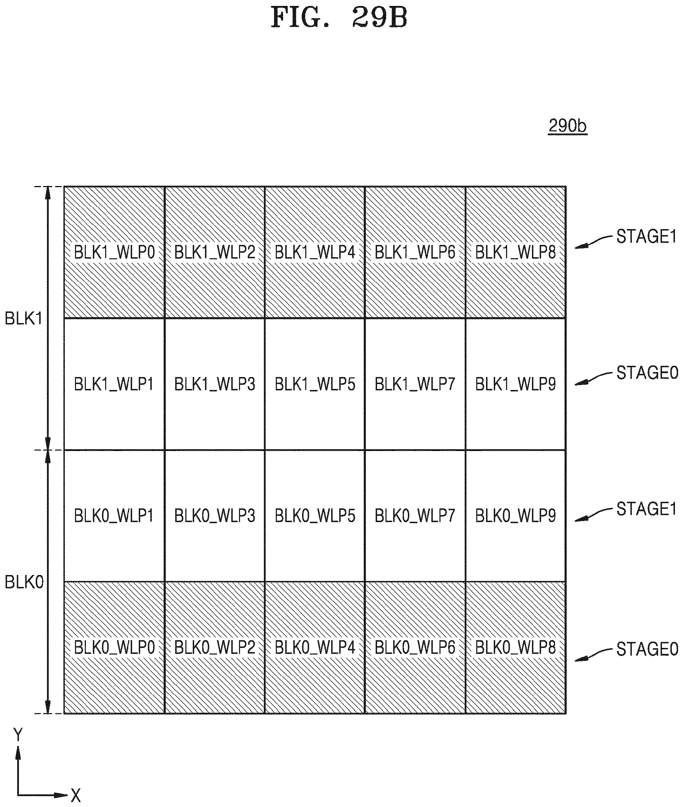

FIG. 29A is a plan view illustrating a pass transistor structure 290a according to an embodiment, and FIG. 29B is a plan view illustrating a word line pad structure 290b according to an embodiment.

Referring to FIG. 29A, pass transistors having a two-stage structure may be disposed in each of first and second memory blocks BLKO and BLK1. Pass transistors provided in a second stage STAGE1 of the first memory block BLKO may share an active area with pass transistors provided in a first stage STAGEO of the second memory block BLK1. Therefore, the pass transistors provided in the second stage STAGE1 of the first memory block BLKO and the pass transistors provided in the first stage STAGEO of the second memory block BLK1 may receive the same word line driving signal in common.

The first and second memory blocks BLKO and BLK1 may be adjacent to each other in a first direction Y, the first memory block BLKO may be referred to as a "lower memory block", and the second memory block BLK1 may be referred to as an "upper memory block". Word line pads WLP corresponding to the first memory block BLKO may be referred to as "lower word line pads", and word line pads corresponding to the second memory block BLK1 may be referred to as "upper word line pads". Word line contacts WLC corresponding to the first memory block BLKO may be referred to as "lower word line contacts", and word line contacts WLC corresponding to the second memory block BLK1 may be referred to as "upper word line contacts". Pass transistors corresponding to the first memory block BLKO may be referred to as "lower pass transistors", and pass transistors corresponding to the second memory block BLK1 may be referred to as "upper pass transistors".

Referring to FIG. 29B, pass transistors having a two-stage structure may be arranged with mirror symmetry in each of first and second memory blocks BLKO and BLK1. Word line pads BLK0_WLP1, BLK0_WLP3, BLK0_WLP5, BLK0_WLP7, and BLK0_WLP9 corresponding to a second stage STAGE1 of a first memory block BLKO and word line pads BLK1_WLP1, BLK1_WLP3, BLK1_WLP5, BLK1_WLP7, and BLK1_WLP9 corresponding to a first stage STAGEO of a second memory block BLK1 may respectively receive the same word line driving signals. Furthermore, word line pads BLK0_WLP0, BLK0_WLP2, BLK0_WLP4, BLK0_WLP6, and BLK0_WLP8 corresponding to the first stage STAGEO of the first memory block BLKO and word line pads BLK1_WLP0, BLK1 _WLP2, BLK1_WLP4, BLK1_WLP6, and BLK1_WLP8 corresponding to the second stage STAGE1 of the second memory block BLK1 may respectively receive the same word line driving signals.

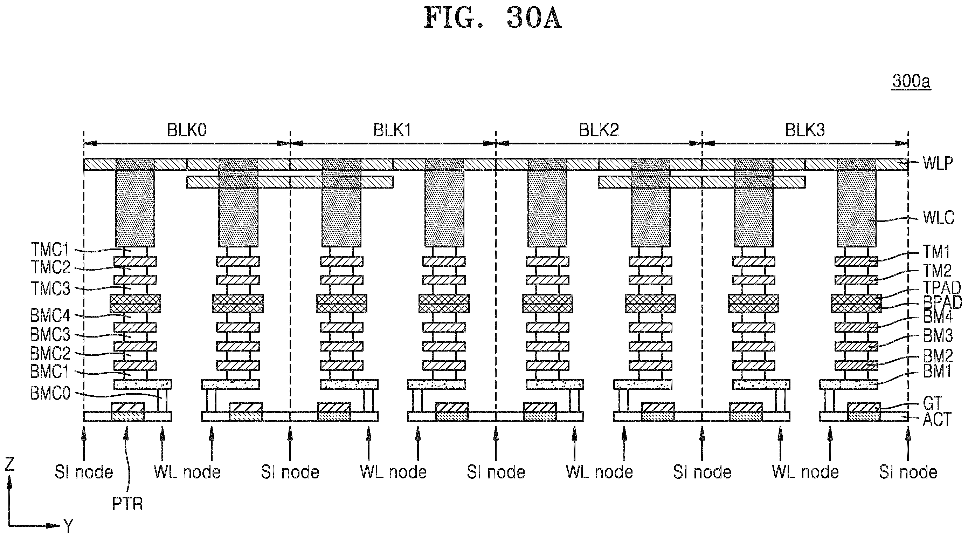

FIG. 30A is a side view illustrating a memory device 300a according to an embodiment. Referring to FIG. 30A, the memory device 300a may include word line pads WLP and pass transistors PTR, which correspond to each of first to fourth memory blocks BLKO to BLK3 arranged in a first direction Y. The word line pads WLP and the pass transistors PTR corresponding to each of the first and second memory blocks BLKO and BLK1 may be arranged with mirror symmetry, and the word line pads WLP and the pass transistors PTR corresponding to each of the third and fourth memory blocks BLK2 and BLK3 may be arranged with mirror symmetry.

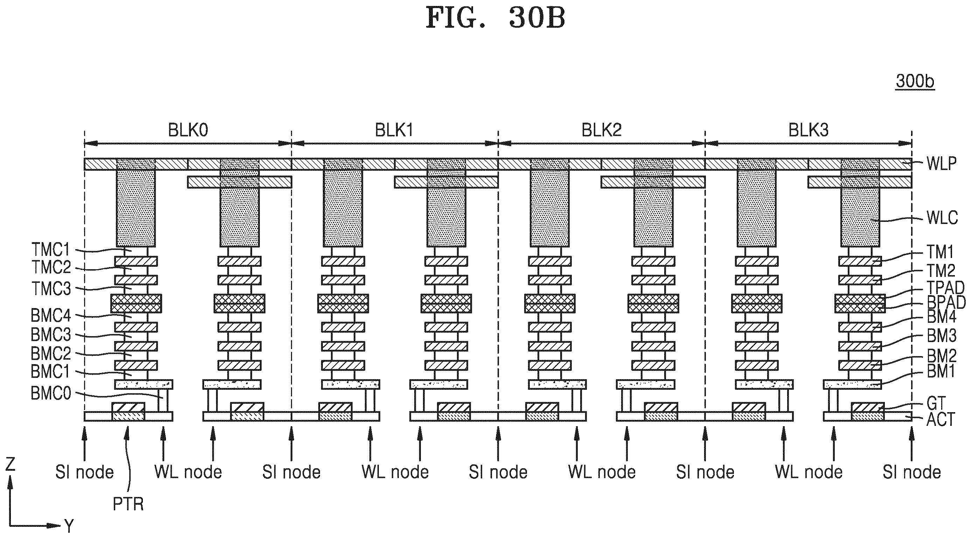

FIG. 30B is a side view illustrating a memory device 300b according to an embodiment. Referring to FIG. 30B, the memory device 300b may include word line pads WLP and pass transistors PTR, which correspond to each of first to fourth memory blocks BLKO to BLK3 arranged in a first direction Y. The word line pads WLP and the pass transistors PTR corresponding to each of the first and second memory blocks BLKO and BLK1 may be arranged as a shift type, and the word line pads WLP and the pass transistors PTR corresponding to each of the third and fourth memory blocks BLK2 and BLK3 may be arranged as a shift type.

FIG. 31A is a plan view illustrating a wiring for a word line driving signal in a memory device 310a according to an embodiment. Referring to FIG. 31A, the memory device 310a may include a plurality of word line pads WLP and a plurality of pass transistors PTR, which are arranged in a first direction Y and a second direction X. First and second word line driving signal lines SIa and SIb may be disposed on the plurality of pass transistors PTR arranged in the first direction Y. In an embodiment, the first and second word line driving signal lines SIa and SIb may be laterally symmetrical with respect to a word line contact WLC.

For example, the first word line driving signal line SIa may be disposed at a left side of the word line contact WLC above the plurality of pass transistors PTR and may be electrically connected to a driving signal line node of a boundary between first and second memory blocks BLKO and BLK1, namely, a driving signal line node of a second stage STAGE1 of a first memory block BLKO and a driving signal line node of a first stage STAGEO of a second memory block BLK1. For example, the second word line driving signal line SIb may be disposed at a right side of the word line contact WLC above the plurality of pass transistors PTR and may be electrically connected to a driving signal line node of a first stage STAGEO of the first memory block BLKO and a driving signal line node of a second stage STAGE1 of the second memory block BLK1.

In some embodiments, the first and second word line driving signal lines SIa and SIb may be alternately arranged. In an embodiment, the first word line driving signal line SIa may be disposed at a left side of the word line contact WLC and the second word line driving signal line SIb may be disposed at a right side of the word line contact WLC, on an odd-numbered column (for example, a column disposed at a leftmost side (i.e., pass transistors adjacent to one another in the first direction Y)), and the second word line driving signal line SIb may be disposed at the left side of the word line contact WLC and the first word line driving signal line SIa may be disposed at the right side of the word line contact WLC, on an even-numbered column (for example, a column disposed at a second-left side (i.e., pass transistors adjacent to one another in the first direction Y)).

FIG. 31B is a plan view illustrating a wiring for a word line driving signal in a memory device 310b according to an embodiment. Referring to FIG. 31B, the memory device 310b may include a plurality of word line pads WLP and a plurality of pass transistors PTR, which are arranged in a first direction Y and a second direction X. First and second word line driving signal lines SIa and SIb may be disposed on the plurality of pass transistors PTR arranged in the first direction Y. In an embodiment, the first and second word line driving signal lines SIa and SIb may be laterally asymmetrical with respect to a word line contact WLC.

The first and second word line driving signal lines SIa and SIb may be disposed at one side (for example, a right side) of the word line contact WLC on the plurality of pass transistors PTR. The first word line driving signal line SIa may be electrically connected to the driving signal line node of the boundary between the first and second memory blocks BLKO and BLK1, namely, the driving signal line node of the second stage STAGE1 of the first memory block BLKO and the driving signal line node of the first stage STAGEO of the second memory block BLK1. For example, the second word line driving signal line SIb may be electrically connected to a driving signal line node of a first stage STAGEO of the first memory block BLKO and a driving signal line node of a second stage STAGE1 of the second memory block BLK1.

In some embodiments, the first and second word line driving signal lines SIa and SIb may be alternately arranged. In an embodiment, the first and second word line driving signal lines SIa and SIb may be disposed in the order of the first and second word line driving signal lines SIa and SIb, on an odd-numbered column (for example, a column disposed at a leftmost side (i.e., pass transistors adjacent to one another in the first direction Y)) and may be disposed in the order of the second and first word line driving signal lines SIb and SIa, on an even-numbered column (for example, a column disposed at a second-left side (i.e., pass transistors adjacent to one another in the first direction Y)).

FIGS. 31A and 31B illustrate an embodiment of a case where block sharing is not performed on first and second memory blocks BLKO and BLK1. However, as described above with reference to FIG. 4, block sharing may be performed on some of a plurality of memory blocks (for example, BLKO to BLKi of FIG. 3). In this case, the number of word line driving signal lines extending in a first direction Y on each pass transistor may correspond to the multiplication of the number of shared memory blocks and the number of stairs of pass transistors corresponding to a block height.

For example, in a case where block sharing is performed on the first and second memory blocks BLKO and BLK1, the number of word line driving signal lines extending in the first direction Y on each pass transistor PTR may be 4 corresponding to the multiplication of the number (i.e., 2) of shared memory blocks and the number (i.e., 2) of stairs of pass transistors corresponding to a block height. In an embodiment, four word line driving signal lines may be arranged in a symmetrical structure with respect to the word line contact WLC, and for example, two word line driving signal lines may be disposed at a left side of the word line contact WLC and two word line driving signal lines may be disposed at a right side of the word line contact WLC. In an embodiment, four word line driving signal lines may be arranged in an asymmetrical structure with respect to the word line contact WLC, and for example, one word line driving signal line may be disposed at the left side of the word line contact WLC and three word line driving signal lines may be disposed at the right side of the word line contact WLC.

For example, in a case where block sharing is performed on three memory blocks including the first and second memory blocks BLKO and BLK1, the number of word line driving signal lines extending in the first direction Y on each pass transistor PTR may be 6 corresponding to the multiplication of the number (i.e., 2) of stairs of pass transistors corresponding to a block height and the number (i.e., 3) of shared memory blocks. In an embodiment, six word line driving signal lines may be arranged in a symmetrical structure with respect to the word line contact WLC, and for example, three word line driving signal lines may be disposed at a left side of the word line contact WLC and three word line driving signal lines may be disposed at the right side of the word line contact WLC. In an embodiment, six word line driving signal lines may be arranged in an asymmetrical structure with respect to the word line contact WLC, and for example, two word line driving signal lines may be disposed at the left side of the word line contact WLC and four word line driving signal lines may be disposed at the right side of the word line contact WLC.

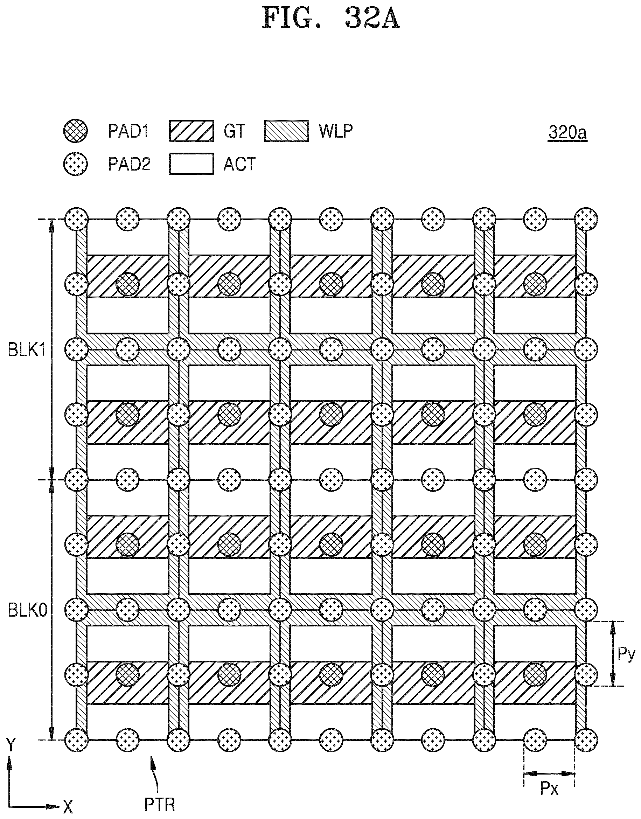

FIG. 32A is a plan view illustrating a memory device 320a according to an embodiment. Referring to FIG. 32A, the memory device 320a may include a plurality of word line pads WLP and a plurality of pass transistors PTR, which are arranged in a first direction Y and a second direction X. The memory device 320a may further include a plurality of bonding pads which have a pitch Py in a first direction Y and have a pitch Px in a second direction X. The plurality of bonding pads may include first bonding pads PAD1 respectively electrically connected to a plurality of word line pads WLP and second bonding pads PAD2 which are not respectively electrically connected to the plurality of word line pads WLP.

The pitch Py of the first and second bonding pads PAD1 and PAD2 in the first direction Y and the pitch Px of the first and second bonding pads PAD1 and PAD2 in the second direction X may all be less than a pitch of the word line pads WLP. The first bonding pads PAD1 may correspond to, for example, the bottom bonding pad BPAD of FIG. 6, but is not necessarily limited thereto. In an embodiment, at least one of the second bonding pads PAD2 may be floated, and thus, may be used as a dummy bonding pad. In an embodiment, at least one of the second bonding pads PAD2 may be used for the other purpose such as a peripheral circuit signal and a power connection. In an embodiment, at least one of the second bonding pads PAD2 may be electrically connected to a ground selection line GSL, a string selection line SSL, an erase control signal line GIDL, or a dummy word line.

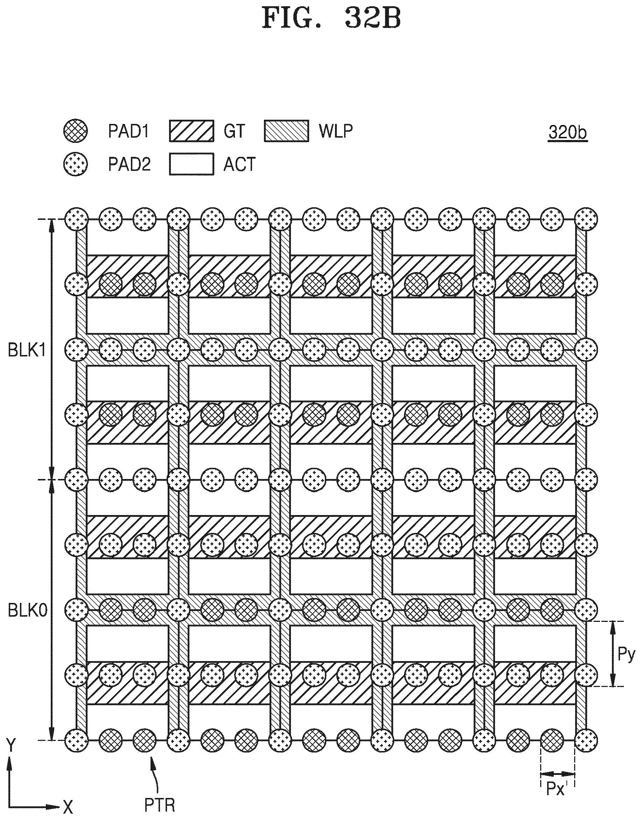

FIG. 32B is a plan view illustrating a memory device 320b according to an embodiment. Referring to FIG. 32B, the memory device 320b may correspond to a modification example of the memory device 320a of FIG. 32A, and the memory device 320b may further include a plurality of bonding pads which have a pitch Py in a first direction Y and have a pitch Px' in a second direction X.

The pitch Py of the first and second bonding pads PAD1 and PAD2 in the first direction Y and the pitch Px' of the first and second bonding pads PAD1 and PAD2 in the second direction X may all be less than a pitch of the word line pads WLP. Also, the pitch Px' of the first and second bonding pads PAD1 and PAD2 in the second direction X may be less than the pitch Px of the first and second bonding pads PAD1 and PAD2 in the second direction X illustrated in FIG. 32A. Also, the first bonding pads PAD1 may correspond to, for example, the bottom bonding pad BPAD of FIG. 6, but is not necessarily limited thereto. In an embodiment, at least one of the second bonding pads PAD2 may be floated, and thus, may be used as a dummy bonding pad. In an embodiment, at least one of the second bonding pads PAD2 may be used for the other purpose such as a peripheral circuit signal and a power connection. In an embodiment, at least one of the second bonding pads PAD2 may be electrically connected to a ground selection line GSL, a string selection line SSL, an erase control signal line GIDL, or a dummy word line.

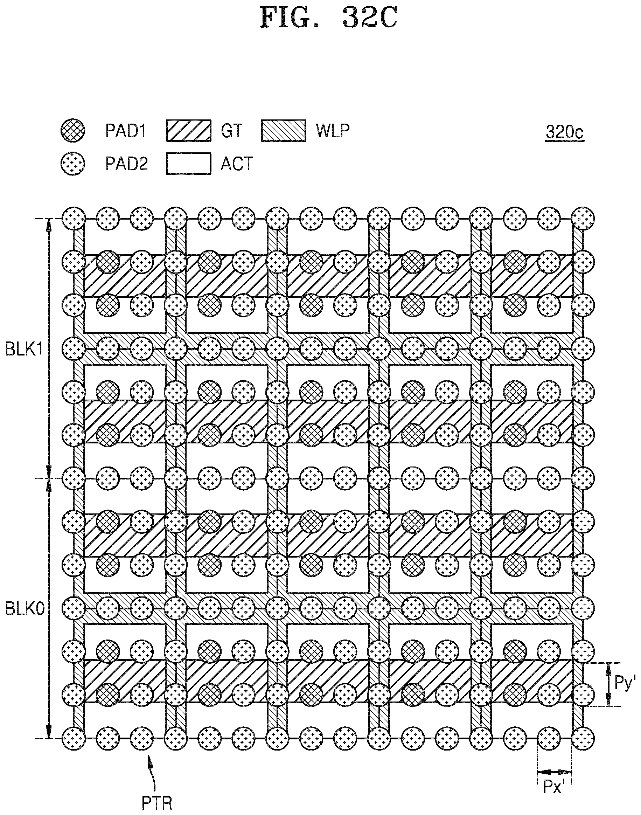

FIG. 32C is a plan view illustrating a memory device 320c according to an embodiment. Referring to FIG. 32C, the memory device 320c may correspond to a modification example of the memory device 320b of FIG. 32B, and the memory device 320c may further include a plurality of bonding pads which have a pitch Py' in a first direction Y and have a pitch Px' in a second direction X.

The pitch Py' of the first and second bonding pads PAD1 and PAD2 in the first direction Y and the pitch Px' of the first and second bonding pads PAD1 and PAD2 in the second direction X may all be less than a pitch of the word line pads WLP. Also, the pitch Py' of the first and second bonding pads PAD1 and PAD2 in the first direction Y may be less than the pitch Py of the first and second bonding pads PAD1 and PAD2 of FIG. 32B in the first direction Y, and the pitch Px' of the first and second bonding pads PAD1 and PAD2 in the second direction X may be equal to the pitch Px' of the first and second bonding pads PAD1 and PAD2 of FIG. 32B in the second direction X. Also, the first bonding pads PAD1 may correspond to, for example, the bottom bonding pad BPAD of FIG. 6, but is not necessarily limited thereto. In an embodiment, at least one of the second bonding pads PAD2 may be floated, and thus, may be used as a dummy bonding pad. In an embodiment, at least one of the second bonding pads PAD2 may be used for the other purpose such as a peripheral circuit signal and a power connection. In an embodiment, at least one of the second bonding pads PAD2 may be electrically connected to a ground selection line GSL, a string selection line SSL, an erase control signal line GIDL, or a dummy word line.

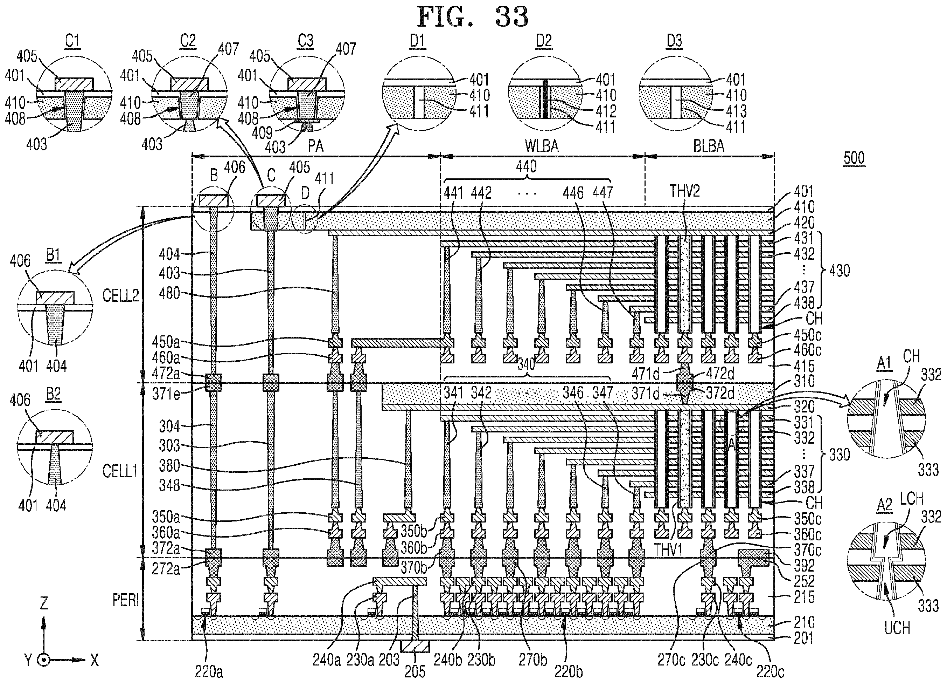

FIG. 33 is a view illustrating a memory device 500 according to some embodiments of the inventive concepts.

Referring to FIG. 33, the memory device 500 may have a chip-to-chip (C2C) structure. At least one upper chip including a cell area and a lower chip including a peripheral circuit region PERI may be manufactured separately, and then, the at least one upper chip and the lower chip may be electrically connected to each other by a bonding method to realize the C2C structure. For example, the bonding method may mean a method of electrically or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. Alternatively, the bonding metal patterns may be formed of aluminum (Al) or tungsten (W).

The memory device 500 may include the at least one upper chip including the cell area. For example, as illustrated in FIG. 33, the memory device 500 may include two upper chips. However, the number of the upper chips is not necessarily limited thereto. In the case in which the memory device 500 includes the two upper chips, a first upper chip including a first cell area CELL1, a second upper chip including a second cell area CELL2 and the lower chip including the peripheral circuit region PERI may be manufactured separately, and then, the first upper chip, the second upper chip and the lower chip may be electrically connected to each other by the bonding method to manufacture the memory device 500. The first upper chip may be turned over and then may be electrically connected to the lower chip by the bonding method, and the second upper chip may also be turned over and then may be electrically connected to the first upper chip by the bonding method. Hereinafter, upper and lower portions of each of the first and second upper chips will be named based on their arrangement before each of the first and second upper chips is turned over. For example, an upper portion of the lower chip may mean an upper portion defined based on a +Z-axis direction, and the upper portion of each of the first and second upper chips may mean an upper portion defined based on a -Z-axis direction in FIG. 33. However, embodiments of the inventive concepts are not necessarily limited thereto. In certain embodiments, one of the first upper chip and the second upper chip may be turned over and then may be electrically connected to a corresponding chip by the bonding method.

Each of the peripheral circuit region PERI and the first and second cell areas CELL1 and CELL2 of the memory device 500 may include an external pad bonding region PA, a word line bonding region WLBA, and a bit line bonding region BLBA.

The peripheral circuit region PERI may include a first substrate 210 and a plurality of circuit elements 220a, 220b and 220c formed on the first substrate 210. An interlayer insulating layer 215 including one or more insulating layers may be provided on the plurality of circuit elements 220a, 220b and 220c, and a plurality of metal lines electrically connected to the plurality of circuit elements 220a, 220b and 220c may be provided in the interlayer insulating layer 215. For example, the plurality of metal lines may include first metal lines 230a, 230b and 230c electrically connected to the plurality of circuit elements 220a, 220b and 220c, and second metal lines 240a, 240b and 240c formed on the first metal lines 230a, 230b and 230c. The plurality of metal lines may be formed of at least one of various conductive materials. For example, the first metal lines 230a, 230b and 230c may be formed of tungsten having a relatively high electrical resistivity, and the second metal lines 240a, 240b and 240c may be formed of copper having a relatively low electrical resistivity.

The first metal lines 230a, 230b and 230c and the second metal lines 240a, 240b and 240c are illustrated and described in the present embodiments. However, embodiments of the inventive concepts are not necessarily limited thereto. In certain embodiments, one or more additional metal lines may further be formed on the second metal lines 240a, 240b and 240c. In this case, the second metal lines 240a, 240b and 240c may be formed of aluminum, and at least some of the additional metal lines formed on the second metal lines 240a, 240b and 240c may be formed of copper having an electrical resistivity that is lower than that of aluminum of the second metal lines 240a, 240b and 240c.

The interlayer insulating layer 215 may be disposed on the first substrate 210 and may include an insulating material such as silicon oxide and/or silicon nitride.

Each of the first and second cell areas CELL1 and CELL2 may include at least one memory block. The first cell area CELL1 may include a second substrate 310 and a common source line 320. A plurality of word lines 330 (331 to 338) may be stacked on the second substrate 310 in a direction (i.e., the Z-axis direction) perpendicular to a top surface of the second substrate 310. String selection lines and a ground selection line may be disposed on and below the word lines 330, and the plurality of word lines 330 may be disposed between the string selection lines and the ground selection line. Likewise, the second cell area CELL2 may include a third substrate 410 and a common source line 420, and a plurality of word lines 430 (431 to 438) may be stacked on the third substrate 410 in a direction (i.e., the Z-axis direction) perpendicular to a top surface of the third substrate 410. Each of the second substrate 310 and the third substrate 410 may be formed of at least one of various materials and may be, for example, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell areas CELL1 and CELL2.

In some embodiments, as illustrated in a region 'A1', the channel structure CH may be provided in the bit line bonding region BLBA and may extend in the direction perpendicular to the top surface of the second substrate 310 to penetrate the word lines 330, the string selection lines, and the ground selection line. The channel structure CH may include a data storage layer, a channel layer, and a filling insulation layer. The channel layer may be electrically connected to a first metal line 350c and a second metal line 360c in the bit line bonding region BLBA. For example, the second metal line 360c may be a bit line and may be electrically connected to the channel structure CH through the first metal line 350c. The bit line 360c may extend in a first direction (e.g., a Y-axis direction) parallel to the top surface of the second substrate 310. The channel layer may be electrically connected to a first metal line 450c and a second metal line 460c in the bit line bonding region BLBA.

In some embodiments, as illustrated in a region 'A2', the channel structure CH may include a lower channel LCH and an upper channel UCH, which are electrically connected to each other. For example, the channel structure CH may be formed by a process of forming the lower channel LCH and a process of forming the upper channel UCH. The lower channel LCH may extend in the direction perpendicular to the top surface of the second substrate 310 to penetrate the common source line 320 and lower word lines 331 and 332. The lower channel LCH may include a data storage layer, a channel layer, and a filling insulation layer and may be electrically connected to the upper channel UCH. The upper channel UCH may penetrate upper word lines 333 to 338. The upper channel UCH may include a data storage layer, a channel layer, and a filling insulation layer, and the channel layer of the upper channel UCH may be electrically connected to the first metal line 350c and the second metal line 360c. As a length of a channel increases, due to characteristics of manufacturing processes, it may be difficult to form a channel having a substantially uniform width. The memory device 500 according to the present embodiments may include a channel having greater width uniformity due to the lower channel LCH and the upper channel UCH which are formed by the processes performed sequentially.

In the case in which the channel structure CH includes the lower channel LCH and the upper channel UCH as illustrated in the region 'A2', a word line located near to a boundary between the lower channel LCH and the upper channel UCH may be a dummy word line. For example, the word lines 332 and 333 adjacent to the boundary between the lower channel LCH and the upper channel UCH may be the dummy word lines. In this case, data might not be stored in memory cells electrically connected to the dummy word line. Alternatively, the number of pages corresponding to the memory cells electrically connected to the dummy word line may be less than the number of pages corresponding to the memory cells electrically connected to a general word line. A level of a voltage applied to the dummy word line may be different from a level of a voltage applied to the general word line, and thus it is possible to reduce an influence of a non-uniform channel width between the lower and upper channels LCH and UCH on an operation of the memory device.

The number of the lower word lines 331 and 332 penetrated by the lower channel LCH is less than the number of the upper word lines 333 to 338 penetrated by the upper channel UCH in the region 'A2'. However, embodiments of the inventive concepts are not necessarily limited thereto. In certain embodiments, the number of the lower word lines penetrated by the lower channel LCH may be equal to or more than the number of the upper word lines penetrated by the upper channel UCH. In addition, structural features and connection relation of the channel structure CH disposed in the second cell area CELL2 may be substantially the same as those of the channel structure CH disposed in the first cell area CELL1.

In the bit line bonding region BLBA, a first through-electrode THV1 may be provided in the first cell area CELL1, and a second through-electrode THV2 may be provided in the second cell area CELL2. As illustrated in FIG. 33, the first through-electrode THV1 may penetrate the common source line 320 and the plurality of word lines 330. In certain embodiments, the first through-electrode THV1 may further penetrate the second substrate 310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In some embodiments, the first through-electrode THV1 and the second through-electrode THV2 may be electrically connected to each other through a first through-metal pattern 372d and a second through-metal pattern 472d. The first through-metal pattern 372d may be formed at a bottom end of the first upper chip including the first cell area CELL1, and the second through-metal pattern 472d may be formed at a top end of the second upper chip including the second cell area CELL2. The first through-electrode THV1 may be electrically connected to the first metal line 350c and the second metal line 360c. The second through-electrode THV2 may be electrically connected to the first metal line 450c and the second metal line 460c. A lower via 371d may be formed between the first through-electrode THV1 and the first through-metal pattern 372d, and an upper via 471d may be formed between the second through-electrode THV2 and the second through-metal pattern 472d. The first through-metal pattern 372d and the second through-metal pattern 472d may be connected to each other by the bonding method.

In addition, in the bit line bonding region BLBA, a top metal pattern 252 may be formed in an uppermost metal layer of the peripheral circuit region PERI, and a top metal pattern 392 having the same shape as the top metal pattern 252 may be formed in an uppermost metal layer of the first cell area CELL1. The top metal pattern 392 of the first cell area CELL1 and the top metal pattern 252 of the peripheral circuit region PERI may be electrically connected to each other by the bonding method. In the bit line bonding region BLBA, the bit line 360c may be electrically connected to a page buffer included in the peripheral circuit region PERI. For example, some of the circuit elements 220c of the peripheral circuit region PERI may constitute the page buffer, and the bit line 360c may be electrically connected to the circuit elements 220c constituting the page buffer through a top bonding metal pattern 370c of the first cell area CELL1 and a top bonding metal pattern 270c of the peripheral circuit region PERI.

Referring continuously to FIG. 33, in the word line bonding region WLBA, the word lines 330 of the first cell area CELL1 may extend in a second direction (e.g., an X-axis direction) parallel to the top surface of the second substrate 310 and may be electrically connected to a plurality of cell contact plugs 340 (341 to 347). First metal lines 350b and second metal lines 360b may be sequentially electrically connected onto the cell contact plugs 340 electrically connected to the word lines 330. In the word line bonding region WLBA, the cell contact plugs 340 may be electrically connected to the peripheral circuit region PERI through top bonding metal patterns 370b of the first cell area CELL1 and top bonding metal patterns 270b of the peripheral circuit region PERI.

The cell contact plugs 340 may be electrically connected to a row decoder included in the peripheral circuit region PERI. For example, some of the circuit elements 220b of the peripheral circuit region PERI may constitute the row decoder, and the cell contact plugs 340 may be electrically connected to the circuit elements 220b constituting the row decoder through the top bonding metal patterns 370b of the first cell area CELL1 and the top bonding metal patterns 270b of the peripheral circuit region PERI. In some embodiments, an operating voltage of the circuit elements 220b constituting the row decoder may be different from an operating voltage of the circuit elements 220c constituting the page buffer. For example, the operating voltage of the circuit elements 220c constituting the page buffer may be greater than the operating voltage of the circuit elements 220b constituting the row decoder.

Likewise, in the word line bonding region WLBA, the word lines 430 of the second cell area CELL2 may extend in the second direction (e.g., the X-axis direction) parallel to the top surface of the third substrate 410 and may be electrically connected to a plurality of cell contact plugs 440 (441 to 447). The cell contact plugs 440 may be electrically connected to the peripheral circuit region PERI through a top metal pattern of the second cell area CELL2 and lower and top metal patterns and a cell contact plug 348 of the first cell area CELL1.

In the word line bonding region WLBA, the top bonding metal patterns 370b may be formed in the first cell area CELL1, and the top bonding metal patterns 270b may be formed in the peripheral circuit region PERI. The top bonding metal patterns 370b of the first cell area CELL1 and the top bonding metal patterns 270b of the peripheral circuit region PERI may be electrically connected to each other by the bonding method. The top bonding metal patterns 370b and the top bonding metal patterns 270b may be formed of aluminum, copper, or tungsten.

In the external pad bonding region PA, a bottom metal pattern 371e may be formed in a lower portion of the first cell area CELL1, and a top metal pattern 472a may be formed in an upper portion of the second cell area CELL2. The bottom metal pattern 371e of the first cell area CELL1 and the top metal pattern 472a of the second cell area CELL2 may be electrically connected to each other by the bonding method in the external pad bonding region PA. Likewise, a top metal pattern 372a may be formed in an upper portion of the first cell area CELL1, and a top metal pattern 272a may be formed in an upper portion of the peripheral circuit region PERI. The top metal pattern 372a of the first cell area CELL1 and the top metal pattern 272a of the peripheral circuit region PERI may be connected to each other by the bonding method.

Common source line contact plugs 380 and 480 may be disposed in the external pad bonding region PA. The common source line contact plugs 380 and 480 may be formed of a conductive material such as a metal, a metal compound, and/or doped polysilicon. The common source line contact plug 380 of the first cell area CELL1 may be electrically connected to the common source line 320, and the common source line contact plug 480 of the second cell area CELL2 may be electrically connected to the common source line 420. A first metal line 350a and a second metal line 360a may be sequentially stacked on the common source line contact plug 380 of the first cell area CELL1, and a first metal line 450a and a second metal line 460a may be sequentially stacked on the common source line contact plug 480 of the second cell area CELL2.

Input/output pads 205, 405 and 406 may be disposed in the external pad bonding region PA. Referring to FIG. 33, a lower insulating layer 201 may cover a bottom surface of the first substrate 210, and a first input/output pad 205 may be formed on the lower insulating layer 201. The first input/output pad 205 may be electrically connected to at least one of a plurality of the circuit elements 220a disposed in the peripheral circuit region PERI through a first input/output contact plug 203 and may be separated from the first substrate 210 by the lower insulating layer 201. In addition, a side insulating layer may be disposed between the first input/output contact plug 203 and the first substrate 210 to electrically isolate the first input/output contact plug 203 from the first substrate 210.

An upper insulating layer 401 covering a top surface of the third substrate 410 may be formed on the third substrate 410. A second input/output pad 405 and/or a third input/output pad 406 may be disposed on the upper insulating layer 401. The second input/output pad 405 may be electrically connected to at least one of the plurality of circuit elements 220a disposed in the peripheral circuit region PERI through second input/output contact plugs 403 and 303, and the third input/output pad 406 may be electrically connected to at least one of the plurality of circuit elements 220a disposed in the peripheral circuit region PERI through third input/output contact plugs 404 and 304.

In some embodiments, the third substrate 410 might not be disposed in a region in which the input/output contact plug is disposed. For example, as illustrated in a region 'B', the third input/output contact plug 404 may be separated from the third substrate 410 in a direction parallel to the top surface of the third substrate 410 and may penetrate an interlayer insulating layer 415 of the second cell area CELL2 so as to be electrically connected to the third input/output pad 406. In this case, the third input/output contact plug 404 may be formed by at least one of various processes.

In some embodiments, as illustrated in a region 'B1', the third input/output contact plug 404 may extend in a third direction (e.g., the Z-axis direction), and a diameter of the third input/output contact plug 404 may become progressively greater toward the upper insulating layer 401. For example, a diameter of the channel structure CH described in the region 'A1' may become progressively smaller toward the upper insulating layer 401, but the diameter of the third input/output contact plug 404 may become progressively greater toward the upper insulating layer 401. For example, the third input/output contact plug 404 may be formed after the second cell area CELL2 and the first cell area CELL1 are bonded to each other by the bonding method.

In certain embodiments, as illustrated in a region 'B2', the third input/output contact plug 404 may extend in the third direction (e.g., the Z-axis direction), and a diameter of the third input/output contact plug 404 may become progressively smaller toward the upper insulating layer 401. For example, like the channel structure CH, the diameter of the third input/output contact plug 404 may become progressively smaller toward the upper insulating layer 401. For example, the third input/output contact plug 404 may be formed together with the cell contact plugs 440 before the second cell area CELL2 and the first cell area CELL1 are bonded to each other.

In certain embodiments, the input/output contact plug may overlap with the third substrate 410. For example, as illustrated in a region 'C', the second input/output contact plug 403 may penetrate the interlayer insulating layer 415 of the second cell area CELL2 in the third direction (e.g., the Z-axis direction) and may be electrically connected to the second input/output pad 405 through the third substrate 410. In this case, a connection structure of the second input/output contact plug 403 and the second input/output pad 405 may be realized by various methods.

In some embodiments, as illustrated in a region 'C1', an opening 408 may penetrate the third substrate 410, and the second input/output contact plug 403 may be electrically connected directly to the second input/output pad 405 through the opening 408 formed in the third substrate 410. In this case, as illustrated in the region 'C1', a diameter of the second input/output contact plug 403 may become progressively greater toward the second input/output pad 405. However, embodiments of the inventive concepts are not necessarily limited thereto, and in certain embodiments, the diameter of the second input/output contact plug 403 may become progressively smaller toward the second input/output pad 405.

In certain embodiments, as illustrated in a region 'C2', the opening 408 penetrating the third substrate 410 may be formed, and a contact 407 may be formed in the opening 408. An end of the contact 407 may be electrically connected to the second input/output pad 405, and another end of the contact 407 may be electrically connected to the second input/output contact plug 403. Thus, the second input/output contact plug 403 may be electrically connected to the second input/output pad 405 through the contact 407 in the opening 408. In this case, as illustrated in the region 'C2', a diameter of the contact 407 may become progressively greater toward the second input/output pad 405, and a diameter of the second input/output contact plug 403 may become progressively smaller toward the second input/output pad 405. For example, the second input/output contact plug 403 may be formed together with the cell contact plugs 440 before the second cell area CELL2 and the first cell area CELL1 are bonded to each other, and the contact 407 may be formed after the second cell area CELL2 and the first cell area CELL1 are bonded to each other.

In certain embodiments illustrated in a region 'C3', a stopper 409 may further be formed on a bottom end of the opening 408 of the third substrate 410, as compared with the embodiments of the region 'C2'. The stopper 409 may be a metal line formed in the same layer as the common source line 420. Alternatively, the stopper 409 may be a metal line formed in the same layer as at least one of the word lines 430. The second input/output contact plug 403 may be electrically connected to the second input/output pad 405 through the contact 407 and the stopper 409.

Like the second and third input/output contact plugs 403 and 404 of the second cell area CELL2, a diameter of each of the second and third input/output contact plugs 303 and 304 of the first cell area CELL1 may become progressively smaller toward the bottom metal pattern 371e or may become progressively greater toward the bottom metal pattern 371e.

In some embodiments, a slit 411 may be formed in the third substrate 410. For example, the slit 411 may be formed at a certain position of the external pad bonding region PA. For example, as illustrated in a region 'D', the slit 411 may be located between the second input/output pad 405 and the cell contact plugs 440 when viewed in a plan view. Alternatively, the second input/output pad 405 may be located between the slit 411 and the cell contact plugs 440 when viewed in a plan view.

In some embodiments, as illustrated in a region 'D1', the slit 411 may penetrate the third substrate 410. For example, the slit 411 may be used to prevent the third substrate 410 from being finely cracked when the opening 408 is formed. However, embodiments of the inventive concepts are not necessarily limited thereto, and in certain embodiments, the slit 411 may have a depth ranging from about 60% to about 70% of a thickness of the third substrate 410.

In certain embodiments, as illustrated in a region 'D2', a conductive material 412 may be formed in the slit 411. For example, the conductive material 412 may be used to discharge a leakage current occurring in driving of the circuit elements in the external pad bonding region PA to the outside. In this case, the conductive material 412 may be electrically connected to an external ground line.

In certain embodiments, as illustrated in a region 'D3', an insulating material 413 may be formed in the slit 411. For example, the insulating material 413 may be used to electrically isolate the second input/output pad 405 and the second input/output contact plug 403 disposed in the external pad bonding region PA from the word line bonding region WLBA. Since the insulating material 413 is formed in the slit 411, it is possible to prevent a voltage provided through the second input/output pad 405 from affecting a metal layer disposed on the third substrate 410 in the word line bonding region WLBA.

In certain embodiments, the first to third input/output pads 205, 405 and 406 may be selectively formed. For example, the memory device 500 may include only the first input/output pad 205 disposed on the first substrate 210, to include only the second input/output pad 405 disposed on the third substrate 410, or to include only the third input/output pad 406 disposed on the upper insulating layer 401.

In some embodiments, at least one of the second substrate 310 of the first cell area CELL1 or the third substrate 410 of the second cell area CELL2 may be used as a sacrificial substrate and may be completely or partially removed before or after a bonding process. An additional layer may be stacked after the removal of the substrate. For example, the second substrate 310 of the first cell area CELL1 may be removed before or after the bonding process of the peripheral circuit region PERI and the first cell area CELL1, and then, an insulating layer covering a top surface of the common source line 320 or a conductive layer for connection may be formed. Likewise, the third substrate 410 of the second cell area CELL2 may be removed before or after the bonding process of the first cell area CELL1 and the second cell area CELL2, and then, the upper insulating layer 401 covering a top surface of the common source line 420 or a conductive layer for connection may be formed.

## Claims

1. A non-volatile memory device (10), comprising:
a first semiconductor layer (L1) including a plurality of memory cells (MC) electrically connected to a plurality of bit lines (BL), each of the plurality of bit lines (BL) extending in a first direction (Y), and a plurality of word lines (WL) stacked in a vertical direction (Z), each of the plurality of word lines (WL) extending in a second direction (X), that is different from the first direction (Y), a plurality of word line pads (WLP0-7) which respectively correspond to the plurality of word lines (WL) and are arranged in a stair shape in the first direction (Y) and in the second direction (X), and a plurality of word line contacts (WLC) respectively electrically connected to the plurality of word line pads (WLP0-7); and
a second semiconductor layer (L2) including a plurality of pass transistors (PTR0-2, 1211-1216, 1211a-c, 1216a-c, 1221-1226) respectively electrically connected to the plurality of word line contacts (WLC), wherein an area of the plurality of the pass transistors (PTR0-2, 1211-1216, 1211a-c, 1216a-c, 1221-1226) is overlapping with an area of the plurality of word line pads (WLP0-7) in the vertical direction (Z),
wherein each of the plurality of word line pads (WLP0-7) has a first width in the first direction (Y) and a second width in the second direction (X),
wherein each of the plurality of pass transistors (PTR0-2, 1211-1216, 1211a-c, 1216a-c, 1221-1226) has a second pitch (P2y) in the first direction (Y) and a second pitch (P2x) in the second direction (X), and
wherein heights of the plurality of word line pads (WLP0-7) in the vertical direction (Z) differ from one another.

2. The non-volatile memory device (10) of claim 1, wherein each of the plurality of word line contacts (WLC) has a first pitch (P1y) in the first direction (Y) and a first pitch (P1x) in the second direction (X).

3. The non-volatile memory device (10) of claim 2, wherein the first width corresponds to the first pitch (P1y) in the first direction (Y), and the second width corresponds to the first pitch (P1x) in the second direction (X).

4. The non-volatile memory device (10) of any one of claims 1 to 3, wherein the plurality of word line contacts (WLC) pass through the plurality of word lines (WL) in the vertical direction, each of the plurality of word line contacts (WLC) extend in the vertical direction, and are respectively electrically connected to the plurality of pass transistors (PTRO-2, 1211-1216, 1211a-c, 1216a-c, 1221-1226).

5. The non-volatile memory device (10) of any one of claims 1 to 3, wherein the plurality of word line contacts (WLC) respectively extend in the vertical direction from the plurality of word lines (WL) and are respectively electrically connected to the plurality of pass transistors (PTR0-2, 1211-1216, 1211a-c, 1216a-c, 1221-1226), and
wherein heights of the plurality of word line contacts (WLC) in the vertical direction differ from one another.

6. The non-volatile memory device (10) of any one of claims 1 to 5, wherein the plurality of word line pads (WLP0-7) comprise first and second word line pads (WLP0-7) adjacent to each other in the first direction (Y),
wherein heights of the first and second word line pads (WLP0-7) differ in the vertical direction, and
wherein the plurality of pass transistors (PTR0-2, 1211-1216, 1211a-c, 1216a-c, 1221-1226) comprise first and second pass transistors (PTR1) (PTR1) adjacent to each other in the first direction (Y), the first pass transistor (PTR0) is electrically connected to the first word line pad through a first word line contact, and the second pass transistor (PTR1) is electrically connected to the second word line pad through a second word line contact.

7. The non-volatile memory device (10) of claim 6, wherein the plurality of word line pads (WLP0-7) further comprise a third word line pad adjacent to the second word line pad in the second direction (X), heights of the second and third word line pads (WLP0-7) differ from one another in the vertical direction, and
wherein the plurality of pass transistors (PTR0-2, 1211-1216, 1211a-c, 1216a-c, 1221-1226) further comprise a third pass transistor (PTR2) adjacent to the second pass transistor (PTR1) in the second direction (X), and the third pass transistor (PTR2) is electrically connected to the third word line pad through a third word line contact.

8. The non-volatile memory device (10) of claim 6 or 7, wherein the first pass transistor (PTR0) comprises a first gate terminal and a first source/drain terminal electrically connected to the first word line contact,
wherein the second pass transistor (PTR1) comprises a second gate terminal and a second source/drain terminal electrically connected to the second word line contact, and
wherein the first and second source/drain terminals are adjacent to each other in the first direction (Y).

9. The non-volatile memory device (10) of claim 6 or 7, wherein the first pass transistor (PTR0) comprises a first gate terminal and a first source/drain terminal electrically connected to the first word line contact,
wherein the second pass transistor (PTR1) comprises a second gate terminal and a second source/drain terminal electrically connected to the second word line contact, and
wherein the first and second source/drain terminals are not adjacent to each other in the first direction (Y).

10. The non-volatile memory device (10) of any one of claims 1 to 9, wherein the first semiconductor layer (L1) further comprises a plurality of top bonding pads respectively electrically connected to the plurality of word line contacts (WLC),
wherein the second semiconductor layer (L2) further comprises a plurality of bottom bonding pads respectively electrically connected to the plurality of pass transistors (PTR0-2, 1211-1216, 1211a-c, 1216a-c, 1221-1226), and
wherein the plurality of top bonding pads and the plurality of bottom bonding pads have a same pitch.

11. The non-volatile memory device (10) of claim 10, wherein the first semiconductor layer (L1) further comprises:
at least one top metal layer including a plurality of top metal patterns respectively electrically connected to the plurality of word line contacts (WLC); and
a plurality of top metal contacts (TMC0-3) respectively electrically connected to the plurality of top metal patterns,
wherein the second semiconductor layer (L2) further comprises:
a plurality of bottom metal contacts (BMC0-3) respectively electrically connected to the plurality of bottom bonding pads; and
at least one bottom metal layer including a plurality of bottom metal patterns respectively electrically connected to the plurality of bottom metal contacts (BMC0-3),
wherein the plurality of word line contacts (WLC), the plurality of top metal patterns, and the plurality of top metal contacts (TMCO-3) have the same pitch as one another, or the plurality of bottom metal contacts (BMCO-3), the plurality of bottom metal patterns, and the plurality of pass transistors (PTRO-2, 1211-1216, 1211a-c, 1216a-c, 1221-1226) have the same pitch as one another.

12. The non-volatile memory device (10) of claim 11, wherein the plurality of top metal contacts (TMCO-3) comprise a plurality of first top metal contacts disposed between a corresponding first top metal pattern of the plurality of top metal patterns and a corresponding first top bonding pad of the plurality of top bonding pads, or
the plurality of bottom metal contacts (BMCO-3) comprise a plurality of first bottom metal contacts disposed between a corresponding first bottom metal pattern of the plurality of bottom metal patterns and a corresponding first bottom bonding pad of the plurality of bottom bonding pads.

13. The non-volatile memory device (10) of claim 10, wherein the first semiconductor layer (L1) further comprises a plurality of top metal contacts (TMCO-3) respectively electrically connected to the plurality of word line contacts (WLC),
wherein the second semiconductor layer (L2) further comprises a plurality of bottom metal contacts (BMCO-3) respectively electrically connected to the plurality of bottom bonding pads, and
wherein the plurality of word line contacts (WLC) and the plurality of top metal contacts (TMCO-3) have a same pitch as one another, or the plurality of bottom metal contacts (BMCO-3) and the plurality of pass transistors (PTRO-2, 1211-1216, 1211a-c, 1216a-c, 1221-1226) have a same pitch as one another.

14. The non-volatile memory device (10) of any one of claims 1 to 3, wherein the plurality of word line contacts (WLC) pass through the plurality of word lines (WL) in the vertical direction,
wherein the second semiconductor layer (L2) further comprises:
at least one bottom metal layer including a plurality of bottom metal patterns respectively electrically connected to the plurality of word line contacts (WLC); and
a plurality of bottom metal contacts (BMCO-3) respectively electrically connected to the plurality of bottom metal patterns,
wherein the plurality of bottom metal patterns, the plurality of bottom metal contacts (BMCO-3), and the plurality of pass transistors (PTRO-2, 1211-1216, 1211a-c, 1216a-c, 1221-1226) have a same pitch.

## Patentansprüche

1. Nichtflüchtige Speichervorrichtung (10), aufweisend:
eine erste Halbleiterschicht (L1), die eine Mehrzahl an Speicherzellen (MC), die mit einer Mehrzahl an Bitleitungen (BL) elektrisch verbunden sind, wobei jede von der Mehrzahl an Bitleitungen (BL) in einer ersten Richtung (Y) verläuft, und eine Mehrzahl an Wortleitungen (WL), die in einer vertikalen Richtung (Z) gestapelt sind, wobei jede von der Mehrzahl an Wortleitungen (WL) in einer zweiten Richtung (X) verläuft, die sich von der ersten Richtung (Y) unterscheidet, eine Mehrzahl an Wortleitungspads (WLP0-7), die der Mehrzahl an Wortleitungen (WL) entsprechen und in einer Treppenform in der ersten Richtung (Y) und in der zweiten Richtung (X) angeordnet sind, und eine Mehrzahl an Wortleitungskontakten (WLC), die jeweils mit der Mehrzahl an Wortleitungspads (WLP0-7) elektrisch verbunden sind, beinhaltet; und
eine zweite Halbleiterschicht (L2), die eine Mehrzahl an Durchlasstransistoren (PTR0-2, 1211-1216, 1211a-c, 1216a-c, 1221-1226) beinhaltet, die mit der Mehrzahl an Wortleitungskontakten (WLC) elektrisch verbunden sind, wobei ein Bereich der Mehrzahl an Durchlasstransistoren (PTR0-2, 1211-1216, 1211a-c, 1216a-c, 1221-1226) sich mit einem Bereich der Mehrzahl an Wortleitungspads (WLP0-7) in der vertikalen Richtung (Z) überlappt,
wobei jedes aus der Mehrzahl an Wortleitungspads (WLP0-7) eine erste Breite in der ersten Richtung (Y) und eine zweite Breite in der zweiten Richtung (X) aufweist,
wobei jeder aus der Mehrzahl an Durchlasstransistoren (PTR0-2, 1211-1216, 1211a-c, 1216a-c, 1221-1226) einen zweiten Pitch (P2y) in der ersten Richtung (Y) und einen zweiten Pitch (P2x) in der zweiten Richtung (X) aufweist, und
wobei sich Höhen der Mehrzahl an Wortleitungspads (WLP0-7) in der vertikalen Richtung (Z) voneinander unterscheiden.

2. Nichtflüchtige Speichervorrichtung (10) nach Anspruch 1, wobei jeder aus der Mehrzahl an Wortleitungskontakten (WLC) einen ersten Pitch (P1y) in der ersten Richtung (Y) und einen ersten Pitch (P1x) in der zweiten Richtung (X) aufweist.

3. Nichtflüchtige Speichervorrichtung (10) nach Anspruch 2, wobei die erste Breite dem ersten Pitch (P1y) in der ersten Richtung (Y) entspricht und die zweite Breite dem ersten Pitch (P1x) in der zweiten Richtung (X) entspricht.

4. Nichtflüchtige Speichervorrichtung (10) nach einem der Ansprüche 1 bis 3, wobei die Mehrzahl an Wortleitungskontakten (WLC) durch die Mehrzahl an Wortleitungen (WL) in der vertikalen Richtung hindurch verlaufen, wobei jeder aus der Mehrzahl an Wortleitungskontakten (WLC) in der vertikalen Richtung verläuft und mit der Mehrzahl an Durchlasstransistoren (PTR0-2, 1211-1216, 1211a-c, 1216a-c, 1221-1226) elektrisch verbunden ist.

5. Nichtflüchtige Speichervorrichtung (10) nach einem der Ansprüche 1 bis 3, wobei die Mehrzahl an Wortleitungskontakten (WLC) von der Mehrzahl an Wortleitungen (WL) aus in der vertikalen Richtung verlaufen und mit der Mehrzahl an Durchlasstransistoren (PTR0-2, 1211-1216, 1211a-c, 1216a-c, 1221-1226) elektrisch verbunden sind, und wobei sich Höhen der Mehrzahl an Wortleitungskontakten (WLC) in der vertikalen Richtung voneinander unterscheiden.

6. Nichtflüchtige Speichervorrichtung (10) nach einem der Ansprüche 1 bis 5, wobei die Mehrzahl an Wortleitungspads (WLP0-7) erste und zweite Wortleitungspads (WLP0-7) aufweisen, die in der ersten Richtung (Y) nebeneinander liegen,
wobei sich Höhen der ersten und zweiten Wortleitungspads (WLP0-7) in der vertikalen Richtung unterscheiden, und
wobei die Mehrzahl an Durchlasstransistoren (PTR0-2, 1211-1216, 1211a-c, 1216a-c, 1221-1226) erste und zweite Durchlasstransistoren (PTR1) (PTR1) aufweisen, die in der ersten Richtung (Y) nebeneinander liegen, wobei der erste Durchlasstransistor (PTR0) mit dem ersten Wortleitungspad durch einen ersten Wortleitungskontakt elektrisch verbunden ist, und wobei der zweite Durchlasstransistor (PTR1) mit dem zweiten Wortleitungspad durch einen zweiten Wortleitungskontakt elektrisch verbunden ist.

7. Nichtflüchtige Speichervorrichtung (10) nach Anspruch 6, wobei die Mehrzahl an Wortleitungspads (WLP0-7) ferner ein drittes Wortleitungspad aufweisen, das sich in der zweiten Richtung (X) neben dem zweiten Wortleitungspad befindet, wobei sich Höhen der zweiten und dritten Wortleitungspads (WLP0-7) in der vertikalen Richtung voneinander unterscheiden, und
wobei die Mehrzahl an Durchlasstransistoren (PTR0-2, 1211-1216, 1211a-c, 1216a-c, 1221-1226) ferner einen dritten Durchlasstransistor (PTR2) aufweist, der sich in der zweiten Richtung (X) neben dem zweiten Durchlasstransistor (PTR1) befindet, und wobei der dritte Durchlasstransistor (PTR2) durch einen dritten Wortleitungskontakt mit dem dritten Wortleitungspad elektrisch verbunden ist.

8. Nichtflüchtige Speichervorrichtung (10) nach Anspruch 6 oder 7, wobei der erste Durchlasstransistor (PTR0) einen ersten Gateanschluss und einen ersten Source/Drain-Anschluss aufweist, der mit dem ersten Wortleitungskontakt elektrisch verbunden ist,
wobei der zweite Durchlasstransistor (PTR1) einen zweiten Gateanschluss und einen zweiten Source/Drain-Anschluss aufweist, der mit dem zweiten Wortleitungskontakt elektrisch verbunden ist, und
wobei sich der erste und zweite Source/Drain-Anschluss in der ersten Richtung (Y) nebeneinander befinden.

9. Nichtflüchtige Speichervorrichtung (10) nach Anspruch 6 oder 7, wobei der erste Durchlasstransistor (PTR0) einen ersten Gateanschluss und einen ersten Source/Drain-Anschluss aufweist, der mit dem ersten Wortleitungskontakt elektrisch verbunden ist,
wobei der zweite Durchlasstransistor (PTR1) einen zweiten Gateanschluss und einen zweiten Source/Drain-Anschluss aufweist, der mit dem zweiten Wortleitungskontakt elektrisch verbunden ist, und
wobei sich der erste und zweite Source/Drain-Anschluss in der ersten Richtung (Y) nicht nebeneinander befinden.

10. Nichtflüchtige Speichervorrichtung (10) nach einem der Ansprüche 1 bis 9, wobei die erste Halbleiterschicht (L1) ferner eine Mehrzahl an oberen Anschlussflächen aufweist, die mit der Mehrzahl an Wortleitungskontakten (WLC) elektrisch verbunden sind,
wobei die zweite Halbleiterschicht (L2) ferner eine Mehrzahl an unteren Anschlussflächen aufweist, die mit der Mehrzahl an Durchlasstransistoren (PTR0-2, 1211-1216, 1211a-c, 1216a-c, 1221-1226) elektrisch verbunden sind, und
wobei die Mehrzahl an oberen Anschlussflächen und die Mehrzahl an unteren Anschlussflächen einen selben Pitch aufweisen.

11. Nichtflüchtige Speichervorrichtung (10) nach Anspruch 10, wobei die erste Halbleiterschicht (L1) ferner aufweist:
zumindest eine obere Metallschicht, die eine Mehrzahl an oberen Metallmustern beinhaltet, die mit der Mehrzahl an Wortleitungskontakten (WLC) elektrisch verbunden sind; und
eine Mehrzahl an oberen Metallkontakten (TMC0-3), die mit der Mehrzahl an oberen Metallmustern elektrisch verbunden sind,
wobei die zweite Halbleiterschicht (L2) ferner aufweist:
eine Mehrzahl an unteren Metallkontakten (BMC0-3), die mit der Mehrzahl an unteren Anschlussflächen elektrisch verbunden sind; und
zumindest eine untere Metallschicht, die eine Mehrzahl an unteren Metallmustern beinhaltet, die mit der Mehrzahl an unteren Metallkontakten (BMC0-3) elektrisch verbunden sind,
wobei die Mehrzahl an Wortleitungskontakten (WLC), die Mehrzahl an oberen Metallmustern, und die Mehrzahl an oberen Metallkontakten (TMC0-3) denselben Pitch aufweisen, oder die Mehrzahl an unteren Metallkontakten (BMC0-3), die Mehrzahl an unteren Metallmustern, und die Mehrzahl an Durchlasstransistoren (PTR0-2, 1211-1216, 1211a-c, 1216a-c, 1221-1226) denselben Pitch aufweisen.

12. Nichtflüchtige Speichervorrichtung (10) nach Anspruch 11, wobei die Mehrzahl an oberen Metallkontakten (TMC0-3) eine Mehrzahl an ersten oberen Metallkontakten aufweist, die sich zwischen einem entsprechenden ersten oberen Metallmuster aus der Mehrzahl an oberen Metallmustern und einer entsprechenden ersten oberen Anschlussfläche aus der Mehrzahl an oberen Anschlussflächen befinden, oder
wobei die Mehrzahl an unteren Metallkontakten (BMC0-3) eine Mehrzahl an ersten unteren Metallkontakten aufweist, die sich zwischen einem entsprechenden ersten unteren Metallmuster aus der Mehrzahl an unteren Metallmustern und einer entsprechenden ersten unteren Anschlussfläche aus der Mehrzahl an unteren Anschlussflächen befinden.

13. Nichtflüchtige Speichervorrichtung (10) nach Anspruch 10, wobei die erste Halbleiterschicht (L1) ferner eine Mehrzahl an oberen Metallkontakten (TMC0-3) aufweist, die mit der Mehrzahl an Wortleitungskontakten (WLC) elektrisch verbunden sind,
wobei die zweite Halbleiterschicht (L2) ferner eine Mehrzahl an unteren Metallkontakten (BMC0-3) aufweist, die mit der Mehrzahl an unteren Anschlussflächen verbunden sind, und
wobei die Mehrzahl an Wortleitungskontakten (WLC) und die Mehrzahl an oberen Metallkontakten (TMC0-3) einen selben Pitch aufweisen, oder die Mehrzahl an unteren Metallkontakten (BMC0-3) und die Mehrzahl an Durchlasstransistoren (PTR0-2, 1211-1216, 1211a-c, 1216a-c, 1221-1226) einen selben Pitch aufweisen.

14. Nichtflüchtige Speichervorrichtung (10) nach einem der Ansprüche 1 bis 3, wobei die Mehrzahl an Wortleitungskontakten (WLC) durch die Mehrzahl an Wortleitungen (WL) in der vertikalen Richtung hindurch verlaufen,
wobei die zweite Halbleiterschicht (L2) ferner aufweist:
zumindest eine untere Metallschicht, die eine Mehrzahl an unteren Metallmustern beinhaltet, die jeweils mit der Mehrzahl an Wortleitungskontakten (WLC) verbunden sind; und
eine Mehrzahl an unteren Metallkontakten (BMC0-3), die jeweils mit der Mehrzahl an unteren Metallmustern elektrisch verbunden sind,
wobei die Mehrzahl an unteren Metallmustern, die Mehrzahl an unteren Metallkontakten (BMC0-3), und die Mehrzahl an Durchlasstransistoren (PTR0-2, 1211-1216, 1211a-c, 1216a-c, 1221-1226) einen selben Pitch aufweisen.

## Revendications

1. Dispositif de mémoire non volatile (10), comprenant :
une première couche semi-conductrice (L1) comprenant une pluralité de cellules de mémoire (MC) électriquement connectées à une pluralité de lignes de bits (BL), chacune de la pluralité de lignes de bits (BL) s'étendant dans une première direction (Y), et une pluralité de lignes de mots (WL) empilées dans une direction verticale (Z), chacune de la pluralité de lignes de mots (WL) s'étendant dans une deuxième direction (X) différente de la première direction (Y), une pluralité de pastilles de ligne de mots (WLP0-7) correspondant respectivement à la pluralité de lignes de mots (WL) et agencées en forme d'escalier dans la première direction (Y) et dans la deuxième direction (X), et une pluralité de contacts de ligne de mots (WLC) respectivement électriquement connectés à la pluralité de pastilles de ligne de mots (WLP0-7) ; et
une deuxième couche semi-conductrice (L2) comprenant une pluralité de transistors de passage (PTRO-2, 1211-1216, 1211a-c, 1216a-c, 1221-1226) respectivement électriquement connectés à la pluralité de contacts de ligne de mots (WLC), dans lequel une zone de la pluralité de transistors de passage (PTRO-2, 1211-1216, 1211a-c, 1216a-c, 1221-1226) est superposé à une zone de la pluralité de pastilles de ligne de mots (WLPO-7) dans la direction verticale (Z),
dans lequel chacune de la pluralité de pastilles de ligne de mots (WLPO-7) présente une première largeur dans la première direction (Y) et une deuxième largeur dans la deuxième direction (X),
dans lequel chacun de la pluralité de transistors de passage (PTRO-2, 1211-1216, 1211a-c, 1216a-c, 1221-1226) présente un deuxième pas (P2y) dans la première direction (Y) et un deuxième pas (P2x) dans la deuxième direction (X), et
dans lequel les hauteurs de la pluralité de pastilles de ligne de mots (WLP0-7) dans la direction verticale (Z) diffèrent les unes des autres.

2. Dispositif de mémoire non volatile (10) selon la revendication 1, dans lequel chacun de la pluralité de contacts de ligne de mots (WLC) présente un premier pas (P1y) dans la première direction (Y) et un premier pas (P1x) dans la deuxième direction (X).

3. Dispositif de mémoire non volatile (10) selon la revendication 2, dans lequel la première largeur correspond au premier pas (P1y) dans la première direction (Y), et la deuxième largeur correspond au premier pas (P1x) dans la deuxième direction (X).

4. Dispositif de mémoire non volatile (10) selon l'une quelconque des revendications 1 à 3, dans lequel la pluralité de contacts de ligne de mots (WLC) traverse la pluralité de lignes de mots (WL) dans la direction verticale, dans lequel chacun de la pluralité de contacts de ligne de mots (WLC) s'étend dans la direction verticale et est électriquement connecté à un transistor de passage respectif (PTRO-2, 1211-1216, 1211a-c, 1216a-c, 1221-1226).

5. Dispositif de mémoire non volatile (10) selon l'une quelconque des revendications 1 à 3, dans lequel les contacts de ligne de mots (WLC) s'étendent respectivement dans la direction verticale depuis la pluralité de lignes de mots (WL) et sont respectivement électriquement connectées à la pluralité de transistors de passage (PTRO-2, 1211-1216, 1211a-c, 1216a-c, 1221-1226), et
dans lequel les hauteurs de la pluralité de contacts de ligne de mots (WLC) dans la direction verticale diffèrent les unes des autres.

6. Dispositif de mémoire non volatile (10) selon l'une quelconque des revendications 1 à 5, dans lequel la pluralité de pastilles de ligne de mots (WLP0-7) comprend des première et deuxième pastilles de ligne de mots (WLP0-7) adjacentes l'une à l'autre dans la première direction (Y),
dans lequel les hauteurs des première et deuxième pastilles de ligne de mots (WLPO-7) diffèrent dans la direction verticale, et
dans lequel la pluralité de transistors de passage (PTRO-2, 1211-1216, 1211a-c, 1216a-c, 1221-1226) comprend des premier et deuxième transistors de passage (PTR1) (PTR1) adjacents l'un à l'autre dans la première direction (Y),
le premier transistor de passage (PTR0) étant électriquement connecté à la première pastille de ligne de mots via un premier contact de ligne de mots, et le deuxième transistor de passage (PTR1) étant électriquement connecté à la deuxième pastille de ligne de mots via un deuxième contact de ligne de mots.

7. Dispositif de mémoire non volatile (10) selon la revendication 6, dans lequel la pluralité de pastilles de ligne de mots (WLP0-7) comprend en outre une troisième pastille de ligne de mots adjacente à la deuxième pastille de ligne de mots dans la deuxième direction (X), dans lequel les hauteurs de la deuxième et de la troisième pastille de ligne de mots (WLPO-7) diffèrent l'une de l'autre dans la direction verticale, et
dans lequel la pluralité de transistors de passage (PTRO-2, 1211-1216, 1211a-c, 1216a-c, 1221-1226) comprend en outre un troisième transistor de passage (PTR2) adjacent au deuxième transistor de passage (PTR1) dans la deuxième direction (X), et le troisième transistor de passage (PTR2) est électriquement connecté à la troisième pastille de ligne de mots via un troisième contact de ligne de mots.

8. Dispositif de mémoire non volatile (10) selon la revendication 6 ou 7, dans lequel le premier transistor de passage (PTR0) comprend une première borne de grille et une première borne source/drain électriquement connectée au premier contact de ligne de mots,
dans lequel le deuxième transistor de passage (PTR1) comprend une deuxième borne de grille et une deuxième borne source/drain électriquement connectée au deuxième contact de ligne de mots, et
dans lequel les première et deuxième bornes source/drain sont adjacentes l'une à l'autre dans la première direction (Y).

9. Dispositif de mémoire non volatile (10) selon la revendication 6 ou 7, dans lequel le premier transistor de passage (PTR0) comprend une première borne de grille et une première borne source/drain électriquement connectée au premier contact de ligne de mots,
dans lequel le deuxième transistor de passage (PTR1) comprend une deuxième borne de grille et une deuxième borne source/drain électriquement connectée au deuxième contact de ligne de mots, et
dans lequel les première et deuxième bornes source/drain ne sont pas adjacentes l'une à l'autre dans la première direction (Y).

10. Dispositif de mémoire non volatile (10) selon l'une quelconque des revendications 1 à 9, dans lequel la première couche semi-conductrice (L1) comprend en outre une pluralité de pastilles de connexion supérieures respectivement électriquement connectées à la pluralité de contacts de ligne de mots (WLC),
dans lequel la deuxième couche semi-conductrice (L2) comprend en outre une pluralité de pastilles de connexion inférieures respectivement électriquement connectées à la pluralité de transistors de passage (PTRO-2, 1211-1216, 1211a-c, 1216a-c, 1221-1226), et dans lequel la pluralité de pastilles de connexion supérieures et la pluralité de pastilles de connexion inférieures présentent un même pas.

11. Dispositif de mémoire non volatile (10) selon la revendication 10, dans lequel la première couche semi-conductrice (L1) comprend en outre :
au moins une couche métallique supérieure comprenant une pluralité de motifs métalliques supérieurs respectivement électriquement connectés à la pluralité de contacts de ligne de mots (WLC), et
une pluralité de contacts métalliques supérieurs (TMCO-3) respectivement électriquement connectés à la pluralité de motifs métalliques supérieurs,
dans lequel la deuxième couche semi-conductrice (L2) comprend en outre :
une pluralité de contacts métalliques inférieurs (BMCO-3) respectivement électriquement connectés à la pluralité de pastilles de connexion inférieures, et
au moins une couche métallique inférieure comprenant une pluralité de motifs métalliques inférieurs respectivement électriquement connectés à la pluralité de contacts métalliques inférieurs (BMCO-3),
dans lequel la pluralité de contacts de ligne de mots (WLC), la pluralité de motifs métalliques supérieurs, et la pluralité de contacts métalliques supérieurs (TMCO-3) présentent un même pas entre eux, ou la pluralité de contacts métalliques inférieurs (BMCO-3), la pluralité de motifs métalliques inférieurs, et la pluralité de transistors de passage (PTRO-2, 1211-1216, 1211a-c, 1216a-c, 1221-1226) présentent un même pas entre eux.

12. Dispositif de mémoire non volatile (10) selon la revendication 11, dans lequel la pluralité de contacts métalliques supérieurs (TMCO-3) comprend une pluralité de premiers contacts métalliques supérieurs disposés entre un motif métallique supérieur correspondant de la pluralité de motifs métalliques supérieurs et une pastille de connexion supérieure correspondante de la pluralité de pastilles de connexion supérieures,
ou dans lequel la pluralité de contacts métalliques inférieurs (BMC0-3) comprend une pluralité de premiers contacts métalliques inférieurs disposés entre un motif métallique inférieur correspondant de la pluralité de motifs métalliques inférieurs et une pastille de connexion inférieure correspondante de la pluralité de pastilles de connexion inférieures.

13. Dispositif de mémoire non volatile (10) selon la revendication 10, dans lequel la première couche semi-conductrice (L1) comprend en outre une pluralité de contacts métalliques supérieurs (TMCO-3) respectivement électriquement connectés à la pluralité de contacts de ligne de mots (WLC),
dans lequel la deuxième couche semi-conductrice (L2) comprend en outre une pluralité de contacts métalliques inférieurs (BMCO-3) respectivement électriquement connectés à la pluralité de pastilles de connexion inférieures, et
dans lequel la pluralité de contacts de ligne de mots (WLC) et la pluralité de contacts métalliques supérieurs (TMCO-3) présentent un même pas entre eux, ou la pluralité de contacts métalliques inférieurs (BMCO-3) et la pluralité de transistors de passage (PTRO-2, 1211-1216, 1211a-c, 1216a-c, 1221-1226) présentent un même pas entre eux.

14. Dispositif de mémoire non volatile (10) selon l'une quelconque des revendications 1 à 3, dans lequel la pluralité de contacts de ligne de mots (WLC) traverse la pluralité de lignes de mots (WL) dans la direction verticale,
dans lequel la deuxième couche semi-conductrice (L2) comprend en outre :
au moins une couche métallique inférieure comprenant une pluralité de motifs métalliques inférieurs respectivement électriquement connectés à la pluralité de contacts de ligne de mots (WLC), et
une pluralité de contacts métalliques inférieurs (BMCO-3) respectivement électriquement connectés à la pluralité de motifs métalliques inférieurs,
dans lequel la pluralité de motifs métalliques inférieurs, la pluralité de contacts métalliques inférieurs (BMCO-3), et la pluralité de transistors de passage (PTRO-2, 1211-1216, 1211a-c, 1216a-c, 1221-1226) présentent un même pas.
